(19) Europäisches Patentamt
European Patent Office
Office européen des brevets

(11) **EP 3 602 601 B1**

(12) **EUROPÄISCHE PATENTSCHRIFT**

(45) Veröffentlichungstag und Bekanntmachung des Hinweises auf die Patenterteilung:
**05.05.2021 Patentblatt 2021/18**

(21) Anmeldenummer: **18715016.4**

(22) Anmeldetag: **29.03.2018**

(51) Int Cl.:
***H01J 37/32*** *(2006.01)*

(86) Internationale Anmeldenummer:
**PCT/EP2018/058193**

(87) Internationale Veröffentlichungsnummer:
**WO 2018/178289 (04.10.2018 Gazette 2018/40)**

(54) **PLASMAGENERATOR, PLASMA-BEHANDLUNGSVORRICHTUNG UND VERFAHREN ZUM GEPULSTEN BEREITSTELLEN VON ELEKTRISCHER LEISTUNG**

PLASMA GENERATOR, PLASMA TREATMENT DEVICE, AND METHOD FOR PROVIDING ELECTRIC POWER IN A PULSED MANNER

GÉNÉRATEUR DE PLASMA, DISPOSITIF DE TRAITEMENT PAR PLASMA ET PROCÉDÉ SERVANT À FOURNIR PAR IMPULSIONS UNE PUISSANCE ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **31.03.2017 DE 102017205582**
**26.03.2018 DE 102018204585**

(43) Veröffentlichungstag der Anmeldung:
**05.02.2020 Patentblatt 2020/06**

(73) Patentinhaber: **centrotherm international AG**
**89143 Blaubeuren (DE)**

(72) Erfinder:
• **SCHULZ, Sebastian Hubertus**
**89143 Blaubeuren (DE)**
• **PERNAU, Thomas**
**89143 Blaubeuren (DE)**
• **NACHBAUER, Florian**
**89143 Blaubeuren (DE)**
• **WALK, Felix**
**89143 Blaubeuren (DE)**

(74) Vertreter: **Klang, Alexander H.**
**Wagner & Geyer Partnerschaft mbB**
**Patent- und Rechtsanwälte**
**Gewürzmühlstrasse 5**
**80538 München (DE)**

(56) Entgegenhaltungen:
WO-A1-2017/011264    JP-A- H03 247 748
KR-A- 20160 049 628    KR-A- 20160 097 438

**Beschreibung**

Die vorliegende Erfindung betrifft eine Plasmagenerator zum gepulsten Bereitstellen von elektrischer Leistung mit einer Frequenz von wenigstens 40kHz eine Plasma-Behandlungsvorrichtung und ein Verfahren zum gepulsten Bereitstellen von elektrischer Leistung mit einer Frequenz von wenigstens 40kHz.

In der Technik sind unterschiedlichste Einsatzgebiete bekannt, in denen eine elektrische Leistung mit einer Frequenz von wenigstens 40kHz bereit gestellt wird, um ein Plasma aus einem Gas anzuregen und für bestimmte Prozesse aufrecht zu erhalten. Ein Beispiel hierfür ist die plasmaunterstützte Gasphasenabscheidung in der Halbleitertechnik oder der Photovoltaikindustrie.

Hierbei werden zum Beispiel Wafer in sogenannten Waferboote geladen, die teilweise aus elektrisch leitenden Platten bestehen und in entsprechende Prozesskammern eingebracht. An die Waferboote wird dann eine elektrische Leistung mit einer Frequenz von wenigstens 140kHz angelegt, um ein Plasma aus einem geeigneten Prozessgas zwischen den Platten und zwischen an den Platten aufgenommenen Wafern zu erzeugen. Ein Beispiel für eine solche Plasma-Behandlungsvorrichtung ist in der DE 10 2015 004 419 A1 der Anmelderin gezeigt.

Solchen Plasma-Behandlungsvorrichtungen bestehen jeweils in der Regel aus einer einzelnen Prozesskammer der ein einzelner Plasmagenerator zugeordnet ist. Bei der benachbarten Anordnung mehrer Prozesskammern wurde zwar zum Teil eine gemeinsame Nutzung von Gasschränken und sonstigen Peripheriegeräten in Betracht gezogen, aber bisher verfügte jede Prozesskammer über einen einzelnen Plasmagenerator. Ein solcher Plasmagenerator besitzt in der Regel ein regelbares Netzteil mit einem Ausgang, das geeignet an seinem Ausgang einen Gleichstrom mit einer vorbestimmten Spannung und/oder Stärke auszugeben, einen Wandler, der geeignet ist, aus einem Gleichstrom am Eingang einen Wechselstrom mit einer vorbestimmten Frequenz von wenigstens 40kHz als ein Ausgangssignal zu formen und das Ausgangssignal an die verbunden Prozesskammer anzulegen. Das Netzteil und der Wandler werden hierbei üblicherweise über einen Regler angesteuert, der die erforderliche Leistung für die Prozesskammer ermittelt und entsprechende Ansteuersignale erzeugt. Üblicherweise ist auch noch eine Bogen-Unterdrückungseinheit vorgesehen, die geeignet aktuelle Prozessdaten über Prozesse der Prozesskammer und aktuelle Daten des Netzteils und/oder des Schalters zu erhalten und in Echtzeit auszuwerten, um einen Überschlag oder einen bevorstehenden Überschlag zu erkennen, wobei die Bogen-Unterdrückungseinheit mit dem Netzteil und/oder dem Schalter in Verbindung steht um diese gegebenenfalls ansprechend auf die Erkennung eines Überschlags oder einen bevorstehenden Überschlags anzusteuern, um Überschläge in der Prozesskammer zu vermeiden oder rasch zu unterdrücken. Während der Prozesse wird die elektrische Leistung üblicherweise vom jeweiligen Plasmagenerator periodisch als Puls zur Verfügung gestellt, wobei hier in der Regel über lange Zeitperioden hinweg ein Tastgrad (Quotient aus Pulsdauer und Periodendauer) von kleiner 0,1 eingestellt wird. Eine derart gepulstes betreiben eines Plasmas in der Prozesskammer hat sich als besonders vorteilhaft erwiesen. Typischerweise bleiben daher über weite Strecken der Prozesse 90% der verfügbaren Dauerleistung eines Plasmagenerators ungenutzt. Es gibt auch Prozesse mit wesentlich kleineren Tastgraden aber auch Prozesse oder Prozeßabschnitte mit höheren Tastgraden. Ferner wird auf die JP H03 247 748 A, hingewiesen, die eine Plasma-Behandlungsvorrichtung zeigt, bei der unterschiedliche Materialien in separaten Vakuumkammer gleichzeitig mit Plasma behandelt werden. Dabei wird die Plasmaenergie in einem Zeit-Teilverfahren über eine Steuerung die entsprechende Schalter ansteuert bereitgestellt. Die Ansteuerung basiert auf Temperatur-Messsignalen der Kammern und den zu behandelnden Materialien.

Der vorliegenden Erfindung liegt daher die Aufgabe zugrunde, die Bereitstellung elektrischer Leistung effizienter zu gestalten. Erfindungsgemäß wird diese Aufgabe durch einen Plasmagenerator nach Anspruch 1 oder 2, eine Plasma-Behandlungsvorrichtung nach Anspruch 10 und ein Verfahren nach Anspruch 11 oder 12 gelöst. Weitere Ausgestaltungen der Erfindung ergeben sich unter anderem aus den Unteransprüchen.

Insbesondere ist ein Plasmagenerator zum gepulsten Bereitstellen von elektrischer Leistung mit einer Frequenz von wenigstens 40kHz an wenigstens zwei Prozesskammern vorgesehen, wobei der Plasmagenerator folgendes aufweist: eine Steuereinheit die geeignet ist Prozessdaten über Prozesse in den wenigstens zwei Prozesskammern zu erhalten und auszuwerten; ein regelbares Netzteil mit einem Ausgang, das geeignet ist ansprechend auf ein Steuersignal von der Steuereinheit an seinem Ausgang einen Gleichstrom mit einer vorbestimmten Spannung und/oder Stärke auszugeben; und eine Schalteinheit mit einem ersten Eingang, der mit dem Ausgang des Netzteils verbunden ist, und mit wenigstens zwei Schalteinheitsausgängen zur jeweiligen Verbindung mit einer der wenigstens zwei Prozesskammern; wobei die Schalteinheit geeignet ist, aus einem Gleichstrom am Eingang einen Wechselstrom mit einer vorbestimmten Frequenz von wenigstens 140kHz als ein Ausgangssignal zu formen und das Ausgangssignal ansprechend auf ein Steuersignal von der Steuereinheit, als einen Puls selektiv für vorbestimmte Pulsdauer an einen der Schalteinheitsausgänge auszugeben; wobei die Steuereinheit geeignet ist Leistungsanforderungen der wenigstens zwei Prozesskammern zu koordinieren und das Netzteil und die Schalteinheit derart anzusteuern, dass an den jeweiligen mit den Prozesskammern in Verbindung stehenden Schalteinheitsausgängen jeweils im Wesentlichen die den Leistungsanforderungen entsprechende Leistung über einen Zeitraum als Pulse zur Verfügung gestellt wird, wobei die Pulse so zeitlich so zueinander versetzt sind, dass die Prozesskammern zeitgleich betrieben werden können.

Ein solcher Plasmagenerator ermöglicht die koordinierte Bereitstellung gepulster Leitung an eine Vielzahl von Prozesskammern, wodurch die Effizienz des Plasmagenerators erhöht wird. Anschaffungskosten für eine Mehrkammer-Plasma-Behandlungs einheit können wesentlich verringert werden, da die Anzahl der erforderlichen Plasmageneratoren wenigstens halbiert wenn nicht noch weiter reduziert werden kann. Insbesondere können Prozesskammern in denen ähnliche Prozesse durchgeführt werden effizient koordiniert werden.

Bei einer Ausführungsform weist die Steuereinheit eine der Anzahl der an die Schalteinheit anzuschließenden Prozesseinheiten entsprechende Anzahl von Reglern aufweist, wobei jeder Regler geeignet ist Prozessdaten über Prozesse in einer jeweiligen der Prozesskammern zu erhalten, wobei jeder Regler mit dem Netzteil und/oder dem Schalter in Verbindung steht um diese ansprechend auf die empfangenen Prozessdaten anzusteuern. Hierdurch kann eine gute und sichere Regelung der jeweiligen Prozesse sichergestellt werden. Ferner weist der Plasmagenerator bevorzugt wenigstens eine Bogen-Unterdrückungseinheit aufweist, die geeignet ist aktuelle Prozessdaten über Prozesse in den wenigstens zwei Prozesskammern und aktuelle Daten des Netzteils und/oder des Schalters zu erhalten und in Echtzeit auszuwerten, um einen Überschlag oder einen bevorstehenden Überschlag zu erkennen, wobei die Bogen-Unterdrückungseinheit mit dem Netzteil und/oder dem Schalter in Verbindung steht um diese gegebenenfalls ansprechend auf die Erkennung eines Überschlags oder einen bevorstehenden Überschlags anzusteuern. Die Bogen-Unterdrückungseinheit kann einen Teil der Steuereinheit bilden.

Die Regler und/oder die wenigstens eine Bogen-Unterdrückungseinheit können als separate Softwaremodule ausgebildet sein, die auf einem gemeinsamen Prozessor oder auf getrennten Prozessoren des Plasmagenerators ausführbar sind.

Bei einer Ausführungsform weist die Schalteinheit wenigstens einen dritten Schalteinheitsausgang auf, der zur Verbindung mit wenigstens einer weiteren Prozesskammer oder einem Absorber geeignet ist, und wobei die Schalteinheit geeignet ist ansprechend auf ein eingehendes Steuersignal von der Steuereinheit das Ausgangssignal als Puls selektiv für eine vorbestimmte Pulsdauer an einen jeweiligen der Schalteinheitsausgänge anzulegen, um eine noch effizientere Ausnutzung des Plasmagenerators zu ermöglichen. Die Schalteinheit kann wenigstens einen Schalteinheitsausgang aufweisen der zur Verbindung mit einem Absorber geeignet ist, wobei die Schalteinheit geeignet ist ansprechend auf ein eingehendes Steuersignal das Ausgangssignal als Puls selektiv für eine vorbestimmte Pulsdauer an den Schalteinheitsausgang für den Absorber anzulegen, um eine Überlastung oder einen Überschlag in einer Prozesskammer zu vermeiden oder zu unterbinden.

Für eine einfache Koordination kann die Steuereinheit so ausgelegt sein, dass sie die Summe aus Pulsdauer und einer entsprechender Pulspause an den jeweiligen Schalteinheitsausgängen so koordiniert, dass die Summe jeweils gleich ist oder an einem der Schalteinheitsausgänge ein Vielfaches der Summe am anderen Schalteinheitsausgang ist.

Bevorzugt ist die Steuereinheit so ausgelegt ist, dass sie Pulse zeitlich bezüglich der Leistungsanforderungen verschiebt, wenn die Leistungsanforderungen zu einem Überlappen von Pulsen an unterschiedlichen Ausgängen führen würde, wobei eine entsprechende zeitliche Verschiebung so gewählt ist, dass der Energieaustrag über die jeweiligen Ausgänge über die Zeit im Wesentlichen der Leistungsanforderung entspricht. Alternativ oder auch zusätzlich kann die Steuereinheit so ausgelegt sein, dass sie einzelne Pulse bezüglich der Leistungsanforderungen in zwei getrennte Pulse aufteilt und zeitlich verschiebt, wenn die Leistungsanforderungen zu einem Überlappen von Pulsen an unterschiedlichen Ausgängen führen würde, wobei eine entsprechende Aufteilung und zeitliche Verschiebung so gewählt ist, dass der Energieaustrag über die jeweiligen Ausgänge über die Zeit im Wesentlichen der Leistungsanforderung entspricht. Auch ist es zusätzlich oder alternativ möglich, dass die Steuereinheit so ausgelegt ist, dass sie einzelne Pulse zeitlich bezüglich der Leistungsanforderungen verschiebt, wenn die Leistungsanforderungen zu einem Überlappen von Pulsen an unterschiedlichen Ausgängen führen würde, wobei eine entsprechende zeitliche Verschiebung so gewählt ist, dass der Energieaustrag über die jeweiligen Ausgänge über die Zeit im Wesentlichen der Leistungsanforderung entspricht. Gemäß einer bevorzugten Ausführungsform ist die Steuereinheit so ausgelegt ist, dass sie wenigstens einen der folgenden Parameter eines Pulses verändern kann: eine Position eines Pulses in einer Pulsfolge, eine Aufteilung eines Pulses in Teilpulse, eine Pulsdauer und eine Amplitude eines Pulses, wenn konkrete Leistungsanforderungen zu einem Überlappen von Pulsen an unterschiedlichen Ausgängen führen würden.

Gemäß einer weiteren Ausführungsform ist der Plasmagenerator zum gepulsten Bereitstellen von elektrischer Leistung mit einer Frequenz von wenigstens 40KHz an wenigstens drei Prozesskammern ausgelegt und aufweist ferner folgendes auf: eine Steuereinheit die geeignet ist Prozessdaten über Prozesse in den wenigstens drei Prozesskammern zu erhalten und auszuwerten; ein weiteres regelbares Netzteil mit einem Ausgang, das geeignet ist ansprechend auf ein Steuersignal von der Steuereinheit an seinem Ausgang einen Gleichstrom mit einer vorbestimmten Spannung und/oder Stärke auszugeben; und eine weitere Schalteinheit mit einem Leistungseingang, der mit dem Ausgang des Netzteils verbunden ist, und mit wenigstens drei Schalteinheitsausgängen zur jeweiligen Verbindung mit einer der wenigstens drei Prozesskammern; wobei die Schalteinheit geeignet ist, aus einem Gleichstrom am Eingang einen Wechselstrom mit einer vorbestimmten Frequenz von wenigstens 40KHz als ein Ausgangssignal zu formen und das Ausgangssignal ansprechend auf ein Steuersignal von der Steuereinheit als Puls selektiv für vorbestimmte Pulsdauern an einen der Schalteinheitsausgänge auszugeben; wobei die Steuereinheit geeignet ist Leistungsanforderungen der wenigstens drei Prozesskammern zu koordinieren und die Netzteile und die Schalteinheiten derart anzusteuern, dass an einem jeweiligen der mit den Prozesskammern in Verbindung stehenden Schalteinheitsausgängen im Wesentlichen jeweils die den Leistungsanforderungen entsprechende Leistung über die Zeit hinweg als Pulse zur Verfügung stehen, wobei die durch eine Schalteinheit bereitgestellten Pulse für die Prozesskammern zeitlich zueinander versetzt sind, während sich die Pulse der zwei Schalteinheiten jedoch überlappen können. Hierdurch kann sich eine höhere Flexibilität der Pulskoordination ergeben. Die Netzteile können unterschiedliche Nennleistungen aufweisen, um für unterschiedlichste Leistungsanforderungen gerüstet zu sein.

Die Erfindung betrifft auch eine Plasma-Behandlungsvorrichtung mit wenigstens zwei getrennten Prozesskammern, in denen jeweils ein Plasma erzeugt werden kann und einem Plasmagenerator des oben beschriebenen Typs, wobei Prozesskammern die jeweils mit einem der Schalteinheitsausgänge der Schalteinheit verbunden sind.

Bei einer Ausführung weist eine solche Plasma-Behandlungsvorrichtung wenigstens drei getrennten Prozesskammern auf, wobei die Schalteinheit des Plasmagenerators wenigstens drei Schalteinheitsausgänge aufweist, und die Prozesskammern jeweils mit einem der Schalteinheitsausgänge verbunden sind. Zusätzlich kann sie auch einen Absorber aufweisen, wobei die Schalteinheit des Plasmagenerators wenigstens drei Schalteinheitsausgänge aufweist, und der Absorber mit einem der Schalteinheitsausgänge verbunden ist.

Die Erfindung betrifft auch ein Verfahren zum gepulsten Bereitstellen von elektrischer Leistung mit einer vorbestimmten Frequenz von wenigstens 40kHz an wenigstens zwei getrennte Prozesskammern, mit folgenden Schritten: Bereitstellen eines Gleichstroms mit einer vorbestimmten Spannung und/oder Stärke an einem Eingang einer Schalteinheit, und zwar ansprechend auf ein Steuersignal von einer Steuereinheit; Formen, aus dem Gleichstrom, eines Wechselstrom-Ausgangssignals mit einer vorbestimmten Frequenz von wenigstens 40kHz in der Schalteinheit und, ansprechend auf ein Steuersignal von der Steuereinheit, selektives Ausgeben des Wechselstrom-Ausgangssignals als Puls mit vorbestimmter Pulsdauer an einem von wenigstens zwei Schalteinheitsausgängen der Schalteinheit, von denen jeder mit einer der wenigstens zwei getrennten Prozesskammern verbunden ist; wobei die Steuereinheit, ansprechend auf Leistungsanforderungen der wenigstens zwei Prozesskammern und ansprechend auf Prozessdaten über Prozesse in den wenigstens zwei Prozesskammern, Steuersignale für das Bereitstellen des Gleichstroms und Steuersignale für selektive Ausgeben des Wechselstrom-Ausgangssignals erzeugt, die so koordiniert sind dass an den jeweiligen der mit den Prozesskammern in Verbindung stehenden Schalteinheitsausgängen jeweils im Wesentlichen die den Leistungsanforderungen entsprechende Leistung über die Zeit hinweg als Pulse zur Verfügung gestellt werden, wobei die Pulse für die Prozesskammern zeitlich zueinander versetzt sind, die Prozesskammern aber zeitgleich betrieben werden. Ein solches Verfahren ermöglicht die schon oben genannten Vorteile einer effizienteren Nutzung eines Plasmagenerators.

Bevorzugt verändert die Steuereinheit wenigstens einen der folgenden Parameter eines Pulses: eine Position eines Pulses in einer Pulsfolge, eine Aufteilung eines Pulses in Teilpulse, eine Pulsdauer und eine Amplitude eines Pulses, wenn konkrete Leistungsanforderungen zu einem Überlappen von Pulsen an unterschiedlichen Ausgängen führen würden. Der Prozess ist so flexibel und kann sich an unterschiedlichste Anforderungen anpassen. Die Steuereinheit kann eine Anpassung nach vorgegebenen festen oder durch einen Bediener einstellbaren Regeln vornehmen. Die Steuereinheit kann die in Pulsen ausgegebene Leistung je Prozesskammer über einen Zeitraum hinweg mit der über den Zeitraum hinweg angeforderten Leistung vergleicht und eine Anpassung wenigstens eines Parameters eines Pulses automatisch anhand des Vergleichs vornehmen.

Bein einer Ausführungsform wird die elektrische Leistung an wenigstens drei getrennte Prozesskammern bereit gestellt, wobei die Schalteinheit wenigstens drei Schalteinheitsausgängen aufweist, von denen jeder mit einer der wenigstens drei getrennten Prozesskammern verbunden ist; wobei die Steuereinheit, ansprechend auf Leistungsanforderungen der wenigstens zwei Prozesskammern und ansprechend auf Prozessdaten über Prozesse in den wenigstens drei Prozesskammern, Steuersignale für das Bereitstellen das Gleichstroms und Steuersignale für selektive Ausgeben des Wechselstrom-Ausgangssignals erzeugt, die so koordiniert sind dass an den jeweiligen der mit den Prozesskammern in Verbindung stehenden Schalteinheitsausgängen jeweils im Wesentlichen die den Leistungsanforderungen entsprechende Leistung über die Zeit hinweg als Pulse zur Verfügung gestellt wird, wobei die Pulse für die Prozesskammern zeitlich zueinander versetzt sind, die Prozesskammern aber zeitgleich betrieben werden.

Bei dem Verfahren kann die Schalteinheit wenigstens drei Schalteinheitsausgängen aufweisen, von denen einer mit einem Absorber verbunden ist, der geeignet ist elektrische Leistung aufzunehmen und zu absorbieren, und wobei die Steuereinheit in der Lage ist die Prozesse in den jeweiligen Prozesskammern zu überwachen und das Auftreten oder die Gefahr eines Überschlages in einer der Prozesskammern zu erkennen, und darauf ansprechend das Ausgangssignal über eine Pulsdauer oder wenigstens einen Teil davon statt in eine entsprechende der Prozesskammern in den Absorber umzuleiten.

Bei dem Verfahren koordiniert die Steuereinheit bei einer Ausführungsform die Summe aus Pulsdauer und einer entsprechender Pulspause an den jeweiligen Schalteinheitsausgängen so, dass die Summe jeweils gleich ist oder an einem Schalteinheitsausgänge ein Vielfaches der Summe an einem anderen Schalteinheitsausgang ist. Bei einer weiteren Ausführungsform ist das Verfahren zum gepulsten Bereitstellen von elektrischer Leistung mit einer vorbestimmten Frequenz von wenigstens 40kHz an wenigstens drei getrennte Prozesskammern, und weist die folgenden weiteren Schritte auf: Bereitstellen eines Gleichstroms mit einer vorbestimmten Spannung und/oder Stärke an einem Eingang einer weiteren Schalteinheit, und zwar ansprechend auf ein Steuersignal von der Steuereinheit; Formen, aus dem Gleichstrom, eines Wechselstrom-Ausgangssignals mit einer vorbestimmten Frequenz von wenigstens 140kHz in der weiteren Schalteinheit und, ansprechend auf ein Steuersignal von der Steuereinheit, selektives Ausgeben des Wechselstrom-Ausgangssignals als Puls mit vorbestimmter Pulsdauer an einem von wenigstens drei Schalteinheitsausgängen der weiteren Schalteinheit, von denen jeder mit einer der wenigstens drei getrennten Prozesskammern verbunden ist; wobei die Steuereinheit, ansprechend auf Leistungsanforderungen der wenigstens drei Prozesskammern und ansprechend auf Prozessdaten über Prozesse in den wenigstens drei Prozesskammern, Steuersignale für das Bereitstellen des Gleichstroms und Steuersignale für selektives Ausgeben des Wechselstrom-Ausgangssignals erzeugt, die so koordiniert sind dass an den jeweiligen der mit den Prozesskammern in Verbindung stehenden Schalteinheitsausgängen jeweils im Wesentlichen die den Leistungsanforderungen entsprechende Leistung über die Zeit hinweg als Pulse zur Verfügung steht, wobei die Pulse die durch eine der Schalteinheiten ausgegeben werden zeitlich zueinander versetzt sind, die Pulse der beiden Schalteinheiten sich aber zeitlich überlappen können.

Die Erfindung wird nachfolgen unter Bezugnahme auf die Zeichnungen noch näher erläutert; in den Zeichnungen zeigt:

Fig. 1 eine schematische Darstellung einer Plasma-Behandlungsvorrichtung mit einem Plasmagenerator gemäß der Erfindung;

Fig. 2 eine schematische Darstellung einer alternativen Plasma-Behandlungsvorrichtung mit einem alternativen Plasmagenerator gemäß der Erfindung;

Fig. 3 eine schematische Darstellung einer weiteren alternativen Plasma-Behandlungsvorrichtung mit einem weiteren alternativen Plasmagenerator gemäß der Erfindung;

Fig. 4 schematische Darstellungen von Pulsfolgen, die von einem Plasmagenerator abgegeben werden, wobei (A) eine normale Pulsfolge eines üblichen Plasmagenerators zeigt, während (B) bis (D) unterschiedliche beispielhafte Pulsfolgen zeigen, die von einem Plasmagenerator gemäß Fig. 1 abgegeben werden;

Fig. 5 schematische Darstellungen von Pulsfolgen, wobei (A) bis (D) unterschiedliche beispielhafte Pulsfolgen zeigen, die von einem Plasmagenerator gemäß Fig. 2 abgegeben werden;

Fig. 6 schematische Darstellungen von Pulsfolgen, wobei (A) eine Pulsfolgenanforderung von Prozesskammern zeigt und (B) eine beispielhafte Pulsfolge, die ansprechend auf die Pulsfolgenanforderung vom Plasmagenerator gemäß Fig. 2 abgegeben wird;

Fig. 7 schematische Darstellungen von beispielhaften Pulsfolgen, die von einem Plasmagenerator gemäß Fig. 3 abgegeben werden, wobei die beiden übereinander angeordneten Darstellungen die Ausgabe an unterschiedlichen Schalteinheiten des Plasmagenerators zeigen;

Fig. 8 schematische Darstellungen von Pulsfolgen, wobei (A) eine Pulsfolgenanforderung von Prozesskammern zeigt und (B) eine beispielhafte Pulsfolge, die ansprechend auf die Pulsfolgenanforderung vom Plasmagenerator gemäß Fig. 2 abgegeben wird;

Fig. 9 schematische Darstellungen von Pulsfolgen, wobei (A) eine Pulsfolgenanforderung von Prozesskammern zeigt und (B) eine beispielhafte Pulsfolge, die ansprechend auf die Pulsfolgenanforderung vom Plasmagenerator gemäß Fig. 2 abgegeben wird;

Fig. 10 schematische Darstellungen von Pulsfolgen, wobei (A) eine Pulsfolgenanforderung von Prozesskammern zeigt und (B) eine beispielhafte Pulsfolge, die ansprechend auf die Pulsfolgenanforderung vom Plasmagenerator gemäß Fig. 2 abgegeben wird.

In der vorliegenden Beschreibung soll der Ausdruck im Wesentlichen Abweichungen von +/-5%, bevorzugt +/- 2%, vom genannten Wert umfassen.

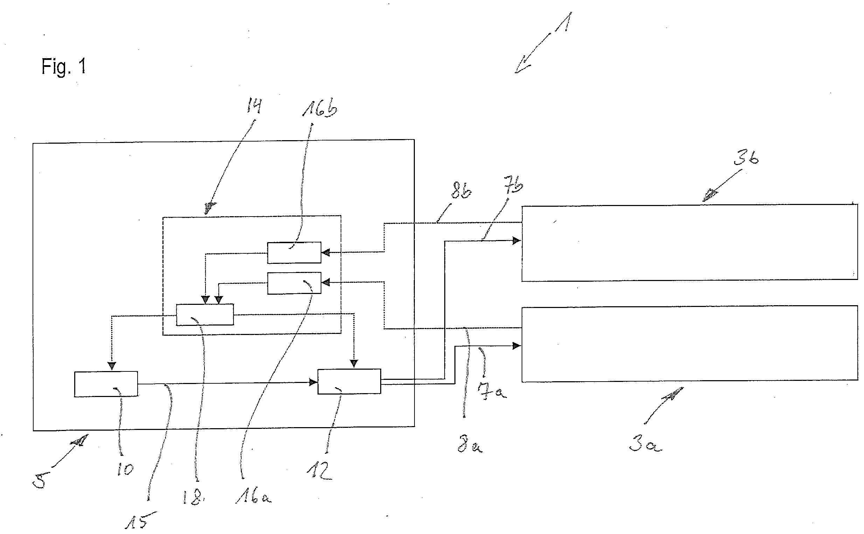

Fig. 1 zeigt eine schematische Darstellung einer ersten Ausführungsform einer Plasma-Behandlungsvorrichtung 1 mit zwei Prozesseinheiten 3a, 3b und einem Plasmagenerator 5. Die Prozesseinheiten 3a und 3b können jeweils den gleichen Aufbau haben und besitzen jeweils eine Prozesskammer zur Aufnahme eines oder mehrerer Substrate, insbesondere Halbleiterwafer oder PV-Substrate. Die Prozesskammern sind dicht verschließbar und die Prozesseinheiten 3a und 3b verfügen über unterschiedliche, nicht dargestellte Mittel zum Einstellen einer gewünschter Gasatmosphäre innerhalb der jeweiligen Prozesskammern, wie beispielsweise Pumpen und ein Gaskabinett. Während jeder Prozesskammer in der Regel eine eigene Pumpe zugeordnet ist, kann ein Gaskabinett ggf. mehrere Prozesskammern versorgen. In den Prozesskammern sind ferner Mittel zum Erzeugen eines Plasmas vorgesehen, wobei diese zum Teil durch ein Waferboot gebildet werden könne, das beispielsweise gemeinsam mit den Substraten in die Prozesskammer eingebracht und dort elektrisch kontaktiert wird, wie es beispielsweise in der oben genannten DE 10 2015 004 419 A1 beschrieben.

Die Prozesseinheiten 3a, 3b stehen über Leistungsleitungen 7a bzw. 7b und Datenverbindungen 8a bzw. 8b mit dem Plasmagenerator 5 in Verbindung. Über die Leistungsleitungen 7a, 7b liefert der Plasmagenerator 5 elektrische Leistung mit einer Frequenz größer 140kHz an die jeweiligen Prozesseinheiten 3a und 3b. Über die Datenverbindungen 8a bzw. 8b können Daten zwischen den Prozesseinheiten 3a, 3b und dem Plasmagenerator 5 ausgetauscht werden. Die Datenverbindungen 8a bzw. 8b können Leitungsgebunden oder auch Drahtlos ausgeführt sein. Insbesondere können die Prozesseinheiten 3a, 3b dem Plasmagenerator 5 unterschiedliche Prozessdaten über Prozesse in den jeweiligen Prozesskammern liefern. Hierbei können insbesondere Ist-Daten hinsichtlich der tatsächlich eingehenden elektrischen Leistung, dem Vorhandensein eines Plasmas etc übermittel werden, aber auch entsprechende Soll-Daten, wie es auch bei schon bekannten Plasma-Behandlungsvorrichtungen mit einer einzelnen Prozesseinheit und einem einzelnen Plasmagenerator der Fall ist.

Der Plasmagenerator 5 besitzt ein regelbares Netzteil 10, eine Schalteinheit 12 sowie eine Steuereinheit 14. Das Netzteil besitzt einen nicht dargestellten Eingang sowie einen Ausgang, der über eine Leistungsleitung 15 mit einem Eingang der Schalteinheit 12 verbunden ist. Das Netzteil 10 ist geeignet ansprechend auf ein Steuersignal von der Steuereinheit 14 an seinem Ausgang einen Gleichstrom mit einer vorbestimmten Spannung und/oder Stärke auszugeben, wie es in der Technik bekannt ist. Die Schalteinheit 12 besitzt den schon genannten Eingang der mit der Leistungsleitung 15 verbunden ist zum Empfang von Gleichstrom von dem Netzteil 10, sowie zwei getrennte Ausgänge, wobei ein Ausgang mit der Leistungsleitung 7a und der andere Ausgang mit der Leistungsleitungen 7b verbunden ist. Die Schalteinheit 12 besitzt eine Wandlerschaltung, die aus einem Gleichstrom am Eingang einen Wechselstrom mit einer vorbestimmten Frequenz von wenigstens 40kHz als ein Ausgangssignal formen kann. Die Wandlerschaltung kann beispielsweise einen Bipolaren Transistor aufweisen, der aus dem vom Netzteil 10 bereitgestellten Gleichstrom ein quasi sinusförmiges Signal (treppenförmiges Signal) bildet. Ferner besitzt die Schalteinheit 12 einen Schaltteil, der das so geformte Ausgangssignal ansprechend auf ein Steuersignal von der Steuereinheit 14 an den einen oder den anderen Ausgang anlegt, mithin an die Prozesseinheit 3a oder die Prozesseinheit 3b.

Die Steuereinheit 14 wiederum verfügt bei der Darstellung über zwei getrennte Regler 16a, 16b, sowie eine Bogen-Unterdrückungseinheit 18. Die Regler 16a, 16b stehen über die Datenverbindungen 8a bzw. 8b mit den Prozesseinheiten 3a bzw. 3b in Verbindung. Die Regler 16a, 16b sind jeweils ausgebildet in bekannter Weise anhand von Ist-Daten und Soll-Daten über die jeweiligen Prozesse in den Prozesseinheiten 3a, 3b Leistungsanforderungen für die Prozesseinheiten 3a, 3b zu ermitteln. Aus diesen erstellen die Regler 16a, 16b (oder eine nachgeschaltete Einheit) dann Ansteuerdaten für das Netzteil 10 und die Schalteinheit 12. Obwohl die Regler 16a, 16b als separate Einheiten dargestellt sind, können Sie auch als eine einzige Einheit ausgebildet ist, welche eine im Wesentlichen parallele Verarbeitung von Daten der Prozesseinheiten 3a und 3b ermöglicht. Insbesondere können die Regler 16a, 16b als separate im Wesentlichen parallel ausführbare Softwareroutinen ausgebildet sein, die auf einem Prozessor ausgeführt werden.

Bei der dargestellten Ausführungsform entsprechende Ausgänge der Regler mit entsprechenden Eingängen der Bogen-Unterdrückungseinheit 18 verbunden. Die Bogen-Unterdrückungseinheit 18 kann somit von den Reglern 16a, 16b die Leistungsanforderungen der einzelnen Prozesseinheiten erhalten, oder auch direkt die hieraus erstellten Ansteuerdaten für das Netzteil 10 und die Schalteinheit 12. Darüber hinaus kann die Bogen-Unterdrückungseinheit 18 aber auch unbearbeitete Daten direkt von den jeweiligen Prozesseinheiten 3a, 3b erhalten. Solche Daten sind insbesondere solche, welche ermöglichen in Echtzeit auszuwerten ob es in einer der Prozesseinheiten 3a und 3b zu einem Überschlag gekommen ist oder ein solcher unmittelbar bevorsteht. Die hierfür erforderlichen Daten sind dem Fachmann bekannt und auch die entsprechenden Erkennungsalgorithmen, die daher hier nicht näher erläutert werden. Im Fall der Erkennung eines Überschlags oder der Gefahr eines solchen kann die Bogen-Unterdrückungseinheit 18 die Ansteuersignale an das Netzteil 10 und die Schalteinheit 12 anpassen und die Bereitstellung der Leistung an die jeweilige Prozesseinheit 3a, 3b in der der Überschlag auftritt oder eine entsprechende Gefahr besteht kurzzeitig unterbrechen.

Die Bogen-Unterdrückungseinheit 18 kann bei dieser Ausführungsform ferner so ausgebildet sein, dass sie beim Erhalt von Leistungsanforderungsdaten der einzelnen Prozesseinheiten hieraus Ansteuerdaten für das Netzteil 10 und die Schalteinheit 12 erstellt. Dies ist natürlich nicht notwendig sofern diese Ansteuerdaten schon von den Reglern 16a, 16b erstellt werden. Darüber hinaus ist die Bogen-Unterdrückungseinheit 18 so ausgebildet, dass sie ihre selbst erstellten bzw. die von den Reglern 16a, 16b erstellten Ansteuerdaten für das Netzteil 10 und die Schalteinheit 12 koordiniert. Die Ansteuerdaten für das Netzteil 10 und die Schalteinheit 12 sind so zu koordinieren, dass den jeweiligen Prozesseinheiten 3a, 3b gemäß Ihren Leistungsanforderungen Leistung zur Verfügung gestellt wird. Darüber hinaus sind die Ansteuerdaten für das Netzteil 10 und die Schalteinheit 12 aber auch zeitlich zu koordinieren, da zu jedem Zeitpunkt nur an einem der Ausgänge der Schalteinheit Leistung zur Verfügung gestellt werden kann. Wie schon oben erläutert, wird die Leistung an die jeweiligen Prozesseinheiten 3a, 3b als Puls mit vorbestimmter Pulsdauer bereitgestellt. Mithin sind die jeweiligen Pulse über die Ansteuerdaten für das Netzteil 10 und die Schalteinheit 12 so zu koordinieren, dass die Pulse nicht überlappen, wobei die Prozesskammern aber trotzdem zeitgleich betrieben werden können.

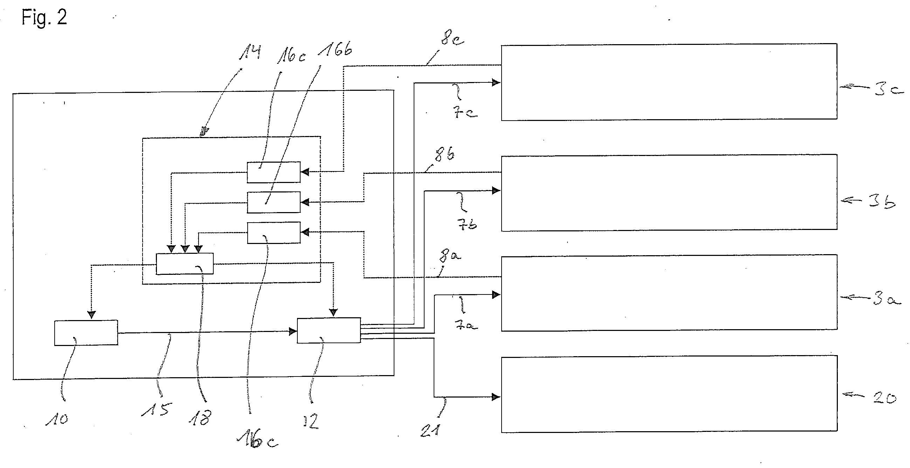

Fig. 2 zeigt eine schematische Darstellung einer alternativen Ausführungsform einer Plasma-Behandlungsvorrichtung 1, die bei dieser Ausführungsform drei Prozesseinheiten 3a, 3b, 3c, einen Absorber 20 und einem Plasmagenerator 5 aufweist. Sofern gleiche oder ähnliche Elemente in den unterschiedlichen Ausführungsformen vorhanden sind, werden dieselben Bezugszeichen verwendet.

Die Prozesseinheiten 3a, 3b und 3c können identisch zu den oben beschriebenen sein und stehen über Leistungsleitungen 7a, 7b bzw. 7c und Datenverbindungen 8a, 8b bzw. 8c mit dem Plasmagenerator 5 in Verbindung. Die Leistungsleitungen 7a, 7b, und 7c dienen wieder zum Liefern elektrischer Leistung mit einer Frequenz größer 40KHz vom Plasmagenerator 5 an die jeweiligen Prozesseinheiten 3a, 3b und 3c. Über die Datenverbindungen 8a, 8b und 8c können wieder Daten zwischen den Prozesseinheiten 3a, 3b, 3c und dem Plasmagenerator 5 ausgetauscht werden.

Der Plasmagenerator 5 besitzt wieder ein regelbares Netzteil 10, eine Schalteinheit 12 sowie eine Steuereinheit 14. Das Netzteil 10 kann identisch zu dem zuvor beschriebenen sein. Die Schalteinheit 12 besitzt wieder einen Eingang über die Leistungsleitung 15 mit dem Ausgang des Netzteils verbunden ist. Bei dieser Ausführungsform besitzt die Schalteinheit aber vier getrennte Ausgänge, wobei drei der Ausgänge mit den Leistungsleitungen 7a, 7b bzw. 7c verbunden sind und der vierte Ausgang über eine Leistungsleitung 21 mit dem Absorber verbunden ist.

Die Schalteinheit 12 besitzt wieder eine Wandlerschaltung, wie oben beschrieben sowie einen Schaltteil, der ein durch die Wandlerschaltung geformtes Ausgangssignal ansprechend auf ein Steuersignal von der Steuereinheit 14 selektiv an einen der Ausgänge anlegt. Mithin kann das Ausgangssignal selektiv an eine der Prozesseinheiten 3a bis 3c oder an den Absorber 20 angelegt werden.

Die Steuereinheit 14 wiederum verfügt bei dieser Ausführungsform über drei getrennte Regler 16a, 16b und 16c, sowie eine Bogen-Unterdrückungseinheit 18. Die Regler 16a, 16b, 16c und stehen über jeweilige Datenverbindungen 8a, 8b bzw. 8c mit den Prozesseinheiten 3a, 3b bzw. 3c in Verbindung. Die Regler 16a, 16b und 16c können wiederum des zuvor beschriebenen Typs sein der ausgebildet ist Leistungsanforderungen für die jeweilige Prozesseinheit 3a, 3b oder 3c zu ermitteln und gegebenenfalls auch Ansteuerdaten für das Netzteil 10 und/oder die Schalteinheit 12.

Auch Bogen-Unterdrückungseinheit 18 kann im Wesentlichen des oben beschriebenen Typs sein, wobei sie bei dieser Ausführungsform drei Prozesseinheiten 3a, 3b und 3c hinsichtlich der Gefahr von Überschlägen überwacht. Ferner koordiniert sie die von der Schalteinheit 12 bereitgestellten Pulse für drei Prozesseinheiten 3a, 3b und 3c.

Die Bogen-Unterdrückungseinheit 18 kann bei dieser Ausführungsform ferner so ausgebildet sein, dass sie beim Erhalt von Leistungsanforderungsdaten der einzelnen Prozesseinheiten hieraus Ansteuerdaten für das Netzteil 10 und die Schalteinheit 12 erstellt. Dies ist natürlich nicht notwendig sofern diese Ansteuerdaten schon von den Reglern 16a, 16b erstellt werden.

Darüber hinaus ist die Bogen-Unterdrückungseinheit 18 so ausgebildet, dass sie ihre selbst erstellten bzw. die von den Reglern 16a, 16b, 16c erstellten Ansteuerdaten für das Netzteil 10 und die Schalteinheit 12 koordiniert. Die Ansteuerdaten für das Netzteil 10 und die Schalteinheit 12 sind so zu koordinieren, dass den jeweiligen Prozesseinheiten 3a, 3b und 3c gemäß Ihren Leistungsanforderungen Leistung zur Verfügung gestellt wird. Darüber hinaus sind die Ansteuerdaten für das Netzteil 10 und die Schalteinheit 12 aber auch zeitlich zu koordinieren, da zu jedem Zeitpunkt nur an einem der Ausgänge der Schalteinheit Leistung zur Verfügung gestellt werden kann. Wie schon oben erläutert, wird die Leistung an die jeweiligen Prozesseinheiten 3a, 3b und 3c als Puls mit vorbestimmter Pulsdauer bereitgestellt. Mithin sind die jeweiligen Pulse über die Ansteuerdaten für das Netzteil 10 und die Schalteinheit 12 so zu koordinieren, dass die Pulse nicht überlappen, wobei die Prozesskammern aber trotzdem zeitgleich betrieben werden können.

Obwohl die Bogen-Unterdrückungseinheit 18 als eine einzelne Einheit dargestellt ist, die sowohl die Bogen-Unterdrückungsfunktion als auch die Puls-Koordinationsfunktion übernimmt, können diese Funktionen auch in getrennten Einheiten durchgeführt werden. Für eine Bogen-Unterdrückungsfunktion könnte die Auswertung der Prozessdaten und der Ansteuerdaten für jede der Prozesskammern getrennt erfolgen und entsprechend könnten drei Einheiten vorgesehen sein (wiederum beispielsweise als separate, parallel laufende Softwareroutinen). Wenn die Bogen-Unterdrückungsfunktion einen Überschlag oder die Gefahr eines solchen feststellt, kann sie die eigentlich für eine der jeweiligen Prozesseinheiten 3a, 3b und 3c vorbereiteten Puls statt in die jeweiligen Prozesseinheit 3a, 3b und 3c zu leiten in den Absorber 20 umleiten, der geeignet ist den Leistungsimpuls aufzunehmen und zum Beispiel in Wärme umzuwandeln. Ein solches Umschalten kann für einen ganzen Puls oder auch für einen Teilpuls erfolgen, wie nachfolgend noch näher erläutert wird.

Für die Puls-Koordinationsfunktion müssen die Daten, insbesondere die Leistungsanforderungsdaten der einzelnen Prozesseinheiten bzw. die gewünschten Ansteuerdaten für das das Netzteil 10 und die Schalteinheit 12 in einer Koordinationsroutine zusammenlaufen. Eine solche kann wie gesagt in der Bogen-Unterdrückungseinheit 18 oder auch in einer separaten Puls-Koordinationseinheit ablaufen. In der Koordinationsroutine werden die durch die Regler ermittelten Leistungsanforderungsdaten der einzelnen Prozesseinheiten bzw. die hieraus erstellten Ansteuerdaten für das das Netzteil 10 und die Schalteinheit 12, zusammengeführt und überprüft, ob Konflikte bestehen. Bei dieser Überprüfung werden darüber hinaus auch Daten über das Netzteil 10 und die Schalteinheit 12, wie beispielsweise Umschaltzeiten, maximale Leistung, maximale Pulsdauer (sofern begrenzt) berücksichtigt. Auch weitere Daten über die jeweiligen Prozesseinheiten 3a, 3b und 3c und die ablaufenden Prozesse können berücksichtigt werden. Solche Daten können zum Beispiel zeitliche Toleranzen bei der Pulszuführung, Toleranzen hinsichtlich der Pulsamplitude, den minimalen erforderlichen und/oder den maximale erlaubten Energieeintrag in den Prozess sowie gegebenenfalls weitere Parameter enthalten. Diese Daten können über einen Prozess hinweg gleichbleibend sein oder sich auch verändern. So gibt es unter anderem Prozesse, bei denen zu bestimmten Zeiten genaue Pulsfolgen mit festgelegter Periodenlänge und mit bestimmten Pulsamplituden einzuhalten sind, während zu anderen Zeiten des Prozesses die Periodenlänge und auch die Pulsamplitude recht flexibel ist, jedoch der Energieeintrag über die Zeit hinweg innerhalb enger Tolleranzen liegt.

Anhand dieser Daten kann die Koordinationseinheit dann die Ausgangspulse an den Ausgängen der Steuereinheit Koordinieren. Bevorzugt werden in den jeweiligen Prozesseinheiten 3a, 3b und 3c Prozesse durchgeführt, welche die Einstellung einer Periodenlänge (Summe aus Pulsdauer und Pulspause) erlaubt, die gleich ist oder für einen der Prozesse ein ganzzahliges Vielfaches der Periodenlänge der anderen Prozesse ist. Dies vereinfacht die Koordination wesentlich, wie nachfolgend Anhand der Pulsdiagramme noch näher erläutert wird, ist aber auch nicht erforderlich. Unterschiedliche Koordinationsmöglichkeiten werden nachfolgend anhand der Pulsdiagramme noch näher erläutert.

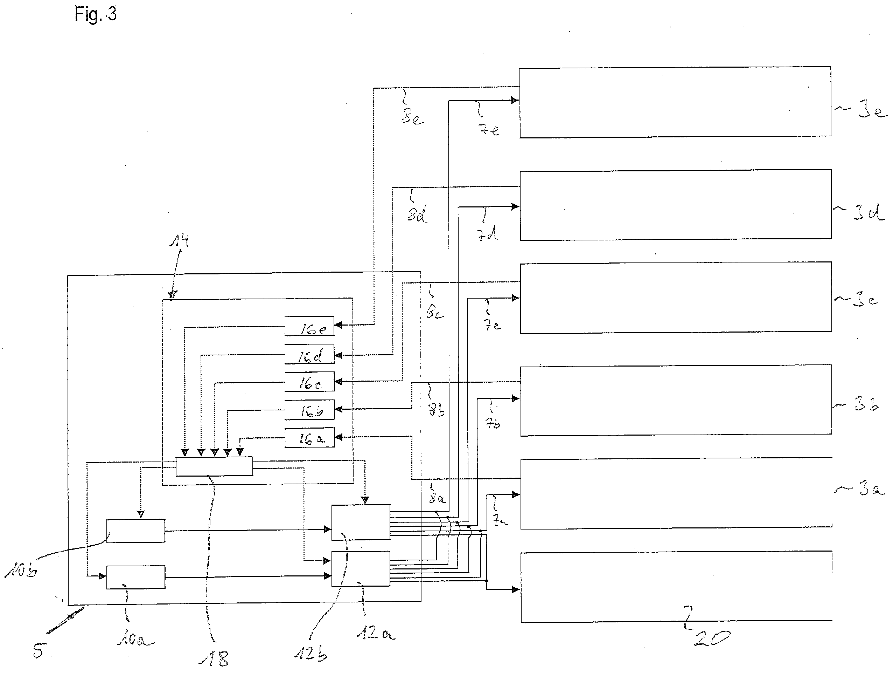

Fig. 3 zeigt eine schematische Darstellung einer weiteren alternativen Ausführungsform einer Plasma-Behandlungsvorrichtung 1. Bei dieser Ausführungsform sind fünf Prozesseinheiten 3a bis 3e, ein Absorber 20 und einem Plasmagenerator 5 vorgesehen. Sofern gleiche oder ähnliche Elemente in den unterschiedlichen Ausführungsformen vorhanden sind, werden wieder dieselben Bezugszeichen verwendet.

Die Prozesseinheiten 3a bis 3e können identisch zu den oben beschriebenen sein und stehen über Leistungsleitungen 7a bis 7e und Datenverbindungen 8a bis 8e mit dem Plasmagenerator 5 in Verbindung. Die Leistungsleitungen 7a bis 7e dienen wieder zum Liefern elektrischer Leistung mit einer Frequenz größer 40kHz vom Plasmagenerator 5 an die jeweiligen Prozesseinheiten 3a bis 3e. Über die Datenverbindungen 8a, 8b und 8c können wieder Daten zwischen den Prozesseinheiten 3a, 3b, 3c und dem Plasmagenerator 5 ausgetauscht werden.

Bei dieser Ausführungsform weist der Plasmagenerator 5 zwei regelbare Netzteile 10a, 10b, zwei Schalteinheiten 12a, 12b sowie eine Steuereinheit 14 auf. Die Netzteile 10a, 10b können kann identisch zu dem zuvor beschriebenen Netzteil sein. Die Netzteile 10a, 10b können hinsichtlich der Nennleistung gleich oder auch unterschiedlich sein. Die Schalteinheiten 12a, 12b besitzen jeweils einen Eingang, der über eine Leistungsleitung 15a bzw. 15b mit dem Ausgang eines der Netzteile verbunden ist. Bei dieser Ausführungsform besitzen die Schalteinheiten 12a, 12b jeweils sechs getrennte Ausgänge, wobei jeweils fünf der Ausgänge mit den Leistungsleitungen 7a bis 7e und somit den Plasmaeinheiten 3a bis 3e verbunden sind und der sechste Ausgang über eine Leistungsleitung 21 mit dem Absorber 20 verbunden ist. Die Schalteinheiten 12a, 12b besitzt jeweils eine Wandlerschaltung, wie oben beschrieben sowie einen Schaltteil, der ein durch die Wandlerschaltung geformtes Ausgangssignal ansprechend auf ein Steuersignal von der Steuereinheit 14 selektiv an einen der Ausgänge anlegt. Mithin kann das Ausgangssignal jeder Schalteinheit 12a, 12b selektiv an eine der Prozesseinheiten 3a bis 3e oder an den Absorber 20 angelegt werden.

Die Steuereinheit 14 wiederum verfügt bei dieser Ausführungsform über fünf getrennte Regler 16a bis 16e, sowie eine Bogen-Unterdrückungseinheit 18. Die Regler 16a bis 16e stehen über jeweilige Datenverbindungen 8a bis 8e mit den Prozesseinheiten 3a bis 3e in Verbindung. Die Regler 16a bis 16e können wiederum des zuvor beschriebenen Typs sein der ausgebildet ist Leistungsanforderungen für die jeweilige Prozesseinheit 3a bis 3e zu ermitteln und gegebenenfalls auch Ansteuerdaten für das Netzteil 10 und/oder die Schalteinheit 12.

Die Bogen-Unterdrückungseinheit 18 ist bei dieser Ausführungsform konfiguriert die fünf Prozesseinheiten 3a bis 3e hinsichtlich der Gefahr von Überschlägen zu überwachen. Ferner ist Sie so konfiguriert, dass sie die erforderlichen Pulse für die Plasmaeinheiten 3a bis 3e über beide Netzteile 10a, 10b und beide Schalteinheiten 12a, 12b verteilt und koordiniert.

Dadurch, dass sie die Bogen-Unterdrückungseinheit 18 die erforderlichen Pulse auf zwei Leistungsversorgungen (Kombination aus Netzteil und Schalteinheit) verteilen kann, ergibt sich eine wesentlich größere Flexibilität hinsichtlich der Verteilung der Pulse. Insbesondere können nun auch zeitlich überlappende Pulse zu Verfügung gestellt werden, wenn dies aufgrund der Leistungsanforderungen notwendig ist, wie nachfolgen noch näher erläutert wird. Eine entsprechende Koordination erfordert, dass an einer Schalteinheit 12a oder 12b die Pulse sequentiell bereit gestellt werden, die Schalteinheiten 12a, 12b aber so angesteuert werden können, dass sie gleichzeitig Pulse liefern. Bei einer gleichzeitigen Lieferung der Pulse über die getrennten Schalteinheiten 12a, 12b sind diese dann aber an separate Plasmaeinheiten 3a bis 3e anzulegen.

Obwohl die Bogen-Unterdrückungseinheit 18 als eine einzelne Einheit dargestellt ist, die sowohl die Bogen-Unterdrückungsfunktion als auch die Puls-Koordinationsfunktion übernimmt, können diese Funktionen auch in getrennten Einheiten durchgeführt werden. Insbesondere wenn die Koordination aufwändiger wird und gegebenenfalls die Bogen-Unterdrückungsfunktion beeinträchtigt, könnte die Puls-Koordinationsfunktion in einer getrennten Einheit erfolgen.

Auch der Plasmagenerator 5 ist als ein einzelner Plasmagenerator mit zwei getrennten Leistungsversorgungen dargestellt. Natürlich könnten auch hier zwei getrennte Plasmageneratoren 5 vorgesehen sein, welche entsprechen jeweils mit den Plasmaeinheiten 3a bis 3e und dem Absorber verbunden sind, und die über eine gemeinsame Steuereinheit entsprechend koordiniert werden. Jedoch wird eine einzelne Einheit bevorzugt, da die Kommunikation zwischen Bogen-Unterdrückungseinheit 18 und dem/den Netzteilen 10a, 10b und der/den Schalteinheiten 12a, 12b über Echtzeit-Datenverbindungen läuft, die Mechanisch empfindlich sind und daher möglichst nicht außerhalb der jeweiligen Einheit verlegt werden sollten.

Wie der Fachmann erkennen kann, sind die Anzahl der zu versorgenden Plasmaeinheiten sowie der Aufbau eines Plasmagenerators nicht auf die konkret dargestellten Ausführungsformen beschränkt. Vielmehr könnten noch mehr Plasmaeinheiten mit einem Plasmagenerator, wie er beispielsweise in Fig. 3 gezeigt ist versorgt werden. Auch ist es möglich bei einer größeren Anzahl von Plasmaeinheiten im Plasmagenerator zum Beispiel drei Leistungsversorgungen vorzusehen, wobei mit steigender Anzahl der Prozesskammer und der Leistungsversorgungen auch die Komplexität der Puls-Koordination zunimmt. Erfindungsgemäß sollte jedoch die Anzahl der Plasmaeinheiten höher sein als die Anzahl der verfügbaren Leistungsversorgungen und insbesondere wenigsten doppelt so hoch sein.

Derzeit wird eine zum Beispiel Plasma-Behandlungsvorrichtung mit acht Plasmaeinheiten (+ 1 optionalen Absorber) und einem Plasmagenerator mit zwei getrennten Leistungsversorgungen, wie in Fig. 3 gezeigt, bzw. mit zwei getrennten Plasmageneratoren und einer gemeinsamen Steuereinheit in Betracht gezogen.

Für die Puls-Koordinationsfunktion können auch bei dieser Ausführungsform dieselben Daten, wie oben beschrieben zusammenlaufen.

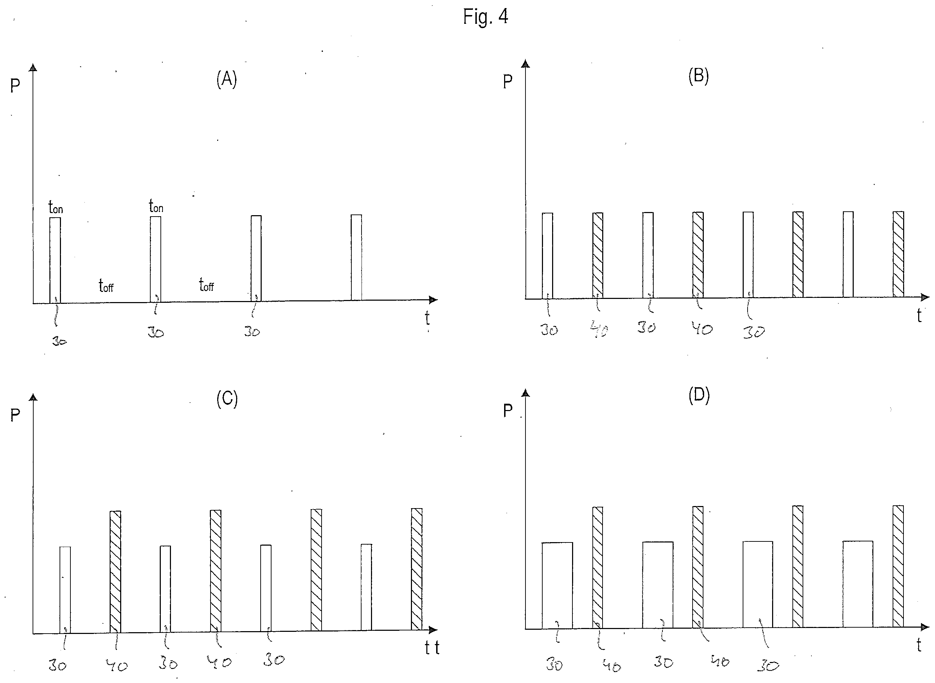

Die Figuren 4 bis 7b zeigen unterschiedliche beispielhafte Pulsfolgen, die über einen Plasmagenerator 5 gemäß der Erfindung bereit gestellt werden können.

Dabei zeigt Fig. 4A eine klassische Pulsfolge, wie sie schon bisher von Plasmageneratoren bereit gestellt wurden. Ein Wechselstrom-Puls 30 mit einer Frequenz von wenigstens 40kHz und einer vorbestimmten Leistung (P) wird für eine vorbestimmte Zeitdauer $t_{on}$ von beispielsweise 5ms ausgegeben. Dann folgt eine Pulspause $t_{off}$ von beispielsweise 45ms gefolgt von einem erneuten Puls mit einer Zeitdauer $t_{on}$ von beispielsweise 5ms. Dies ist eine typische Abfolge von Leistungspulsen wie sie für die Plasmabehandlung in einer Plasmaeinheit bereitgestellt wird. Hier ergibt sich eine Periodendauer von 50ms und ein Tastgrad von 0,1. Mithin bleiben hier beispielsweise 90% der verfügbaren Dauerleistung des verwendeten Plasmagenerators ungenutzt.

Fig. 4B zeigt eine alternative Pulsfolge, wie sie von einem Plasmagenerator gemäß der Erfindung, wie er zum Beispiel in Fig. 1 gezeigt ist, zur Verfügung gestellt werden kann. Die beispielhafte Pulsfolge besteht aus Pulsen 30 und Pulsen 40, wobei die Pulse 30 zum Beispiel der Prozesseinheit 3a und die Pulse 40 der Prozesseinheit 3b zur Verfügung gestellt werden. Bei dieser Pulsfolge haben die Pulse 30 und 40 jeweils die gleiche Leistung und die gleiche Pulsdauer $t_{on}$ von beispielsweise 5ms. Zwischen den Pulsen 30 - 30 / 40 - 40 für die jeweilige Prozesseinheit 3a/3b gibt es jeweils eine Pulspause toff von beispielsweise 45ms. Zwischen den Pulsen 30 - 40 - 30 ergibt sich hingegen jeweils eine Pulspause $t_{off}$ von beispielsweise 20ms. Während jede einzelne Prozesseinheit 3a, 3b mit einem Tastgrad von 0,1 betrieben wird, wird der Plasmagenerator mit einem Tastgrad von 0,2 betrieben und mithin wesentlich besser ausgelastet.

Fig. 4C zeigt eine weitere beispielhafte Pulsfolge, wie sie von einem Plasmagenerator gemäß der Erfindung, wie er zum Beispiel in Fig. 1 gezeigt ist, zur Verfügung gestellt werden kann. Die beispielhafte Pulsfolge besteht wieder aus Pulsen 30 und Pulsen 40, wobei die Pulse 30 zum Beispiel der Prozesseinheit 3a und die Pulse 40 der Prozesseinheit 3b zur Verfügung gestellt werden. Bei dieser Pulsfolge haben die Pulse 30 und 40 jeweils unterschiedliche Leistung jedoch wieder die gleiche Pulsdauer $t_{on}$ von beispielsweise 5ms und auch die gleichen Pulspausen, wie in Fig. 4B. Hier soll gezeigt werden, dass der Plasmagenerator in der Lage ist nicht nur gleiche Pulse zu verschachteln sondern auch Pulse mit unterschiedlicher Leistung zur Verfügung zu stellen, was beispielsweise über eine entsprechende Ansteuerung des Netzteils 10 möglich ist.

Fig. 4D zeigt eine weitere beispielhafte Pulsfolge, wie sie von einem Plasmagenerator gemäß der Erfindung, wie er zum Beispiel in Fig. 1 gezeigt ist, zur Verfügung gestellt werden kann. Die beispielhafte Pulsfolge besteht wieder aus Pulsen 30 und Pulsen 40, wobei die Pulse 30 zum Beispiel der Plasmaeinheit 3a und die Pulse 40 der Prozesseinheit 3b zur Verfügung gestellt werden. Bei dieser Pulsfolge haben die Pulse 30 und 40 wie auch schon bei Fig. 4C jeweils unterschiedliche Leistung und diesmal auch unterschiedliche Pulsdauer $t_{on}$ von beispielsweise 15ms für die Pulse 30 und 5ms für die Pulse 40. Die Pulspausen zwischen den Pulsen 30 - 40 beträgt jeweils beispielsweise 10ms und zwischen den Pulsen 40 - 30 jeweils beispielsweise 20ms. Wie zu erkennen ist lassen sich die Pulse für Plasmaprozesse, die mit jeweils gleicher Periodenlänge gepulst werden (oder mit Periodenlängen die ein Vielfaches voneinander sind), leicht verschachteln und mit einem einzelnen Plasmagenerator bereitstellen.

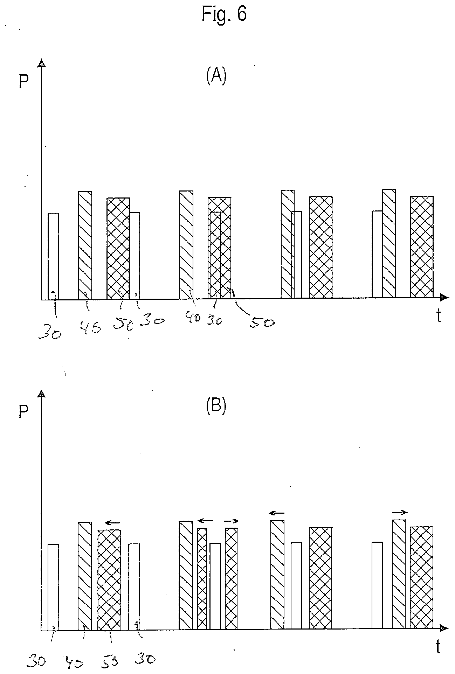

Aber auch Prozesse, die mit jeweils unterschiedlichen Periodenlängen gepulst werden, die keine Vielfachen voneinander sind, lassen sich mit einem einzelnen Plasmagenerator bereitstellen. Hierzu können, da jeweils zu einem Zeitpunkt nur für eine Plasmaeinheit ein Puls bereit gestellt werden kann ein zeitliche Pulsverschiebung des einen und/oder anderen Pulses, oder ein Teilen und teilweises Verschieben eines Pulses eingesetzt werden, wie nachfolgen unter Bezugnahme auf Figur 6 noch näher erläutert wird. Hierbei wird versucht auf die Erfordernisse der jeweiligen Plasmaeinheit einzugehen, sodass zum Beispiel Verschiebungen/Aufteilungen nur innerhalb zulässiger Toleranzen erfolgen. Dabei kann eine entsprechende Steuereinheit zur Ansteuerung einer Leistungsversorgung (Kombination aus Netzteil und Schalteinheit) entsprechende Daten auswerten und gegebenenfalls auch einen oder mehre Zyklen voraus schauen, um zu erkennen wann Konflikte zwischen Pulsen zu erwarten sind, um gegebenenfalls Verschiebungen vorbereiten. Wenn zum Beispiel eine maximale Pulspause $t_{off}$ in einem Prozess - mit einer normalen Pulspause von 45ms - 50ms beträgt, aber in zwei Zyklen eine Verschiebung von +10ms erforderlich ist, so kann in zwei aufeinanderfolgenden Zyklen jeweils eine +5ms Verschiebung erfolgen, sodass in zwei aufeinanderfolgenden Zyklen eine 50ms Pulspause entsteht. Dabei sollten Verschiebungen aber bevorzugt so gewählt werden, dass über längere Zeiträume von beispielsweise 50 Zyklen ein Energieeintrag in den Prozess den Leistungsanforderungen entspricht oder über die Zeit unverändert bleibt.

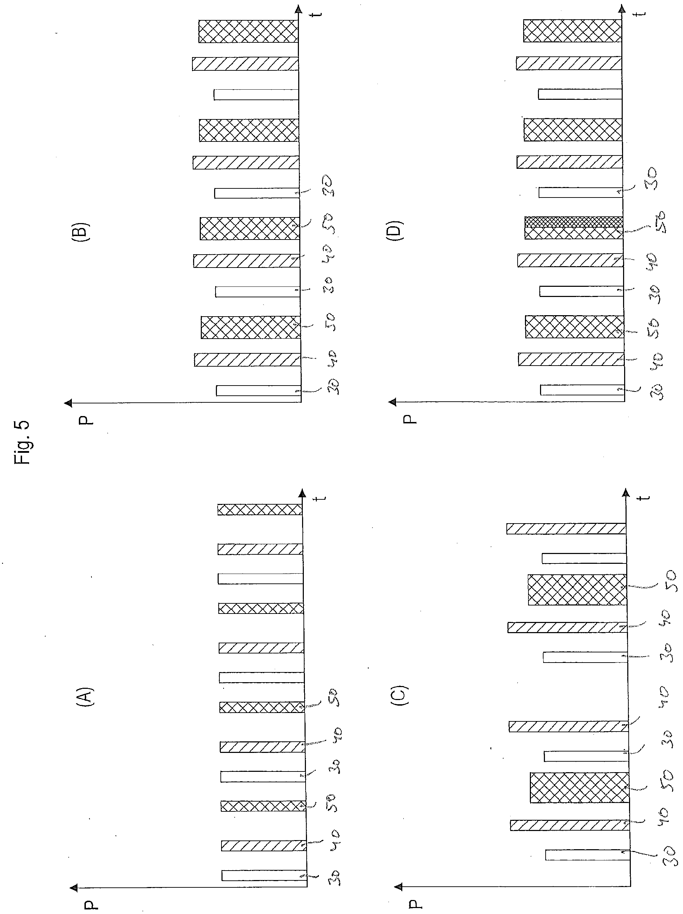

Die Figuren 5A bis 5D zeigen unterschiedliche beispielhafte Pulsfolgen, die beispielsweise über einen Plasmagenerator 5 gemäß Fig. 2 bereitgestellt werden. Dabei werden zum Beispiel drei unterschiedliche Pulse 30, 40, 50 für unterschiedliche Prozesseinheiten 3a bis 3c bereit gestellt.

Fig. 5A zeigt eine Pulsfolge mit Pulsen 30, 40, 50, die jeweils dieselbe Pulsdauer $t_{on}$ von beispielsweise 5ms und dieselbe Leitung besitzen. Zwischen den Pulsen 30 - 30 /40 - 40 /50 - 50 für die jeweilige Prozesseinheit 3a/3b/3c gibt es jeweils eine Pulspause $t_{off}$ von beispielsweise 45ms. Zwischen den Pulsen 30 - 40 - 50 - 30 ergeben sich Pulspausen $t_{off}$ von beispielsweise 10ms - 15ms - 10ms. Während jede einzelne Prozesseinheit 3a, 3b mit einem Tastgrad von 0,1 betrieben wird, wird der Plasmagenerator nun mit einem Tastgrad von 0,3 betrieben.

Auch die Fig. 5B zeigt eine Pulsfolge mit Pulsen 30, 40, 50, die sich jedoch hinsichtlich ihrer Pulsdauern $t_{on}$ und auch hinsichtlich ihrer Leistung unterscheiden. Jedoch besitzen die Pulse 30 - 30 / 40 - 40 / 50 - 50 jeweils wieder dieselbe Periodenlänge von zum Beispiel 50ms, sodass die Pulse leicht zu verschachteln sind.

Fig. 5C zeigt eine weitere beispielhafte Pulsfolge ähnlich Fig. 5B mit Pulsen 30, 40, 50, die sich hinsichtlich ihrer Pulsdauern $t_{on}$ und auch hinsichtlich ihrer Leistung unterscheiden. Darüber hinaus besitzen die Pulse 30 - 30 /40 - 40 jeweils dieselbe Periodenlänge zum Beispiel 50ms, während die Pulse 50 - 50 eine doppelt so lange Periodenlänge von beispielsweise 100ms besitzen. Auch hier ist leichte eine Verschachtelung der Pulse möglich.

Fig. 5D zeigt eine weitere beispielhafte Pulsfolge ähnlich Fig. 5B mit Pulsen 30, 40, 50, die sich hinsichtlich ihrer Pulsdauern $t_{on}$ und auch hinsichtlich ihrer Leistung unterscheiden, jedoch die Pulse 30 - 30 / 40 - 40 / 50 - 50 jeweils wieder dieselbe Periodenlänge besitzen. Diese Pulsfolge zeigt jedoch beispielhaft den Eingriff der die Bogen-Unterdrückungseinheit 18 in die reguläre Pulsfolge. So wurde während der ersten Hälfte des zweiten Pulses 50 ein Überschlag in der Plasmaeinheit 3c festgestellt, woraufhin die Bogen-Unterdrückungseinheit 18 die Schalteinheit 12 in Echtzeit angesteuert hat, um die zweite Hälfte des Pulses 50 in den Absorber umzuleiten. Dies ist rasch möglich und es werden keine Leistungsschwankungen in den nachfolgenden Pulsen erzeugt, was bei einer einfachen Trennung der Plasmaeinheit 3c vom Plasmagenerator 5 auftreten könnte, da die Leistung ja schon in der Schalteinheit bereitgestellt wird.

Die Figur 6 zeigt bei (A) eine beispielhafte Pulsfolgenanforderung (Leistungsanforderung) von drei Prozesskammern, die zum Beispiel von der Bogen-Unterdrückungseinheit 18 gemäß Fig. 2 verarbeitet und koordiniert werden soll und bei (B) eine beispielhafte Pulsfolge, die ansprechend auf die Pulsfolgenanforderung vom Plasmagenerator gemäß Fig. 2 abgegeben wird.

Wie in Fig. 6A zu erkennen ist werden Pulsen 30, 40, 50 mit unterschiedlichen Pulsdauern und unterschiedlichen Leistungen angefordert, wobei ein entsprechendes Anforderungsprofil beispielsweise durch die Regler 16a bis 16c erstellt wird. Darüber besitzen die Pulse 30 - 30 /40 - 40 / 50 - 50 auch unterschiedliche Periodenlängen, sodass die Pulsfolgenanforderung Pulse zum Teil überlappend oder direkt hintereinander anfordert.

Da dies nicht möglich ist muß nun die Bogen-Unterdrückungseinheit 18 oder eine andere Steuereinheit die auszugebenden Pulse so koordinieren, dass sie in geeigneter Weise ausgegeben werden, wobei hier die Bedürfnisse der Plasmaeinheiten möglichst berücksichtigt werden. Bei dem Beispiel gemäß Fig. 6 wurde angenommen, dass die Pulse 30 keinerlei Änderung erfahren dürfen, da die entsprechende Plasmaeinheit zumindest während der aktuellen Phase des Prozesses keine Abweichungen erlaubt. Somit stimmen die ausgegebenen Pulse 30 (siehe Fig. 6B) genau mit den angeforderten Pulsen überein. Die Prozesse in den Plasmaeinheiten 3b und 3c erlauben hingegen Abweichungen an den Pulsen innerhalb vorgegebener Grenzen, solange der Gesamt Energieeintrag über die Zeit Konstant bleibt. Mithin wird der erste Puls 50 in Fig. 6B gegenüber seiner Anforderung (die direkt an eine Pulsanforderung für einen Puls 30 angrenzt) zeitlich leicht nach vorne verschoben, um die Umschaltzeit der Steuereinheit 12 von beispielsweise 1 ms zu berücksichtigen. Der zweite Puls 50, der gemäß Pulsanforderung vollständig mit einem Puls 30 überlappen würde wurde hier auf zwei Teile 50-1, 50-2 aufgeteilt, wobei der Teil 50-1 zeitlich vor den entsprechenden Puls 30 und der Teil 50-2 zeitlich hinter den Puls 30 verschoben wurde. Hierbei entspricht die Summe der Dauer der Teilpulse 50-1, 50-2 der Dauer eines normalen Pulses 50. Neben einer solchen Aufteilung wäre es gegebenenfalls auch möglich gewesen den Puls 50 vollständig hinter den Puls 30 zu verschieben, sofern eine maximale erlaubt Pulspause zwischen Pulsen 50 - 50 dabei nicht überschritten worden wäre. Auch die dritten und vierten Pulse 40 wurden zeitlich verschoben, um eine ordnungsgemäße Pulsfolge zu ermöglichen. Sofern keiner der überlappenden Pulse zwingend zu einem bestimmten Zeitpunkt erfolgen muss, können bei überlappenden Pulsen auch beide verschoben werden, wobei die Verschiebung dann üblicherweise gegenläufig sein wird. Während der Eine nach vorne verschoben wird, wird der Andere nach hinten verschoben. Hierdurch können gegebenenfalls geforderte Pulspausen zwischen gleichen Pulsen einer Kammer besser beibehalten werden.

Aus der Fig. 6 ergeben sich unterschiedliche Möglichkeiten, wie Pulsfolgen anhand von ermittelten Leistungsanforderungen sowie den Bedürfnissen der Plasmaeinheiten erstellt werden können. Der Fachmann wird aus der grundsätzlichen Lehre der Erfindung unterschiedlichste Konzepte für die Koordination der Pulse erkennen, die wie oben angedeutet auch vorausschauend sein können.

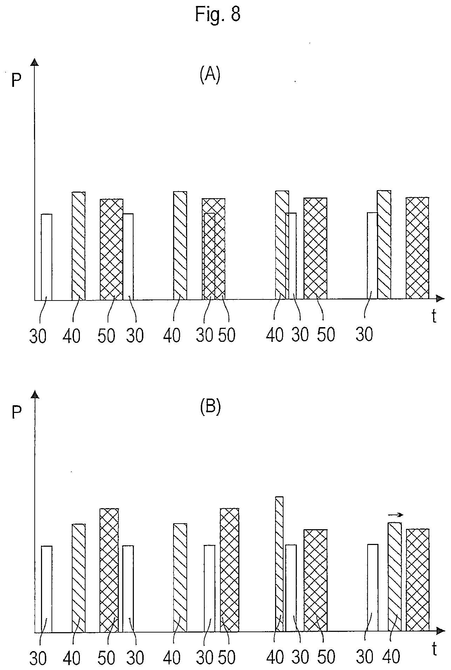

Neben, oder auch zusätzlich zu einer Verschiebung und/oder einem Zerteilen der Pulse ist es auch möglich die jeweilige Pulshöhe und/oder die jeweilige Pulsdauer zu verändern. Ein Beispiel hierfür ist in den Figuren 8 (A) und (B) angedeutet. Die Figur 8(A) zeigt wiederum eine beispielhafte Pulsfolgenanforderung (Leistungsanforderung) von drei Prozesskammern, während Fig. 8 (B) eine beispielhafte Pulsfolgenausgabe zeigt. Insbesondere ist die Pulsfolgenanforderung dieselbe wie in Fig. 6(A) und wieder werden die Pulse 30 als nicht veränderbar angesehen. Die Pulsfolgenausgabe gemäß Fig. 8(B) ist aber von der Gemäß Fig. 6(B) unterschiedlich. So wurde der erste Puls 50 nicht wie in Fig. 6(B) zeitlich nach vorne verschoben. Vielmehr entspricht der Pulsbeginn der Anforderung. Jedoch wurde der Puls zeitlich verkürzt, dafür aber erhöht. Mithin wurde während der kurzen Zeitdauer eine höhere Leistung bereitgestellt, sodass die Gesamtleistung des Pulses gleich oder ungefähr gleich der angeforderten Leistung ist. Der zweite Puls 50 wurde nicht geteilt sondern zeitlich hinter den überlappend angeforderten Puls 30 verschoben. Gleichzeitig wurde der Puls zeitlich gekürzt und die Leistung erhöht, wie bei dem ersten Puls 50. Dies kann gegenüber einer Teilung beispielsweise von Vorteil sein, um minimale Pulspausen zwischen aufeinanderfolgenden Pulsen einer Kammer beizubehalten. Der dritte Puls 40 wurde ähnlich wie der erste Puls 50 behandelt, sprich die angeforderte Anfangszeit wurde beibehalten, während die Pulsdauer verkürzt und die Pulshöhe vergrößert wurden. Beim vierten Puls 40 wurde hingegen zwar die Anfangszeit verschoben, aber die Endzeit gemäß Anforderung beibehalten. Wiederum verkürzt sich hierdurch die Pulsdauer, was durch eine Erhöhung der Pulshöhe kompensiert wurde. Mithin zeigt Fig. 8(B) ein alternatives Pulsmanagement, das bei gleicher Ausgangslage wie bei Fig. 6(A) komplett ohne eine Pulsverschiebung auskommt. Als Pulsverschiebung wird hier eine Verschiebung sowohl der Anfangszeit als auch der Endzeit gegenüber der Anforderung angesehen. Wenn wenigstens einer der Zeitpunkte gemäß Anforderung erfolgt wird dies nicht als Verschiebung angesehen.

Anhand der Fig. 8 erkennt der Fachmann, dass neben der Verschiebung und der Aufteilung von Pulsen noch weitere Konzepte für die Koordination der Pulse bereitstehen. Natürlich können die Konzepte auch miteinander vermischt werden insbesondere ist es auch möglich einen Puls sowohl zu verschieben als auch hinsichtlich der Pulshöhe und/oder der Pulsdauer zu modulieren.

Auch wenn dies nicht dargestellt ist, ist es auch möglich einen Puls ganz entfallen zu lassen, sofern eine der obigen Maßnahmen nicht möglich oder zweckmäßig ist. Hierbei sollte der Energieeintrag über die Zeit hinweg jedoch nicht wesentlich beeinflusst werden. Der Begriff über die Zeit hinweg kann je nachdem Prozess relativ kurz gefasst sein, wenn zum Beispiel ein Mindestenergieeintrag pro Zeiteinheit (z.B. Millisekunde) nicht unterschritten werden darf, da hier die entsprechende Zeiteinheit berücksichtigt werden muss. Der Begriff kann aber auch den ganzen Prozess an sich umfassen, wenn es zum Beispiel im Wesentlichen auf die gesamt eingebrachte Energie in den Prozess ankommt. Bei kurzen Zeiträumen könnten zum Beispiel bei einem Total- oder auch Teilausfall eines Pulses dann ggf. der vorhergehende und/oder nachfolgende Puls entsprechend erhöht oder verlängert werden. Bei längeren Zeiträumen können Pulse eventuell auch wesentlich später nachgeliefert werden, um zum Beispiel nach einem planmäßigen Ende eines Prozesses. Das Pulsmanagement ist so konfiguriert, dass es unter Berücksichtigung der Fähigkeiten der eingesetzten Komponenten, wie Netzteil 10 und/oder Schalter 12 für verschiedenste Anforderungen der Kammern die optimale Konfiguration aus Pulsdauer, Pulsverschiebung, Pulsleistungshöhe und/oder Pulszerteilung wählt. Als optimal wird hier eine möglichst geringe Prozessbeeinflussung angesehen. Dabei kann es zur Verbesserung eines konstanten Energieeintrags auch zweckmäßig sein nicht nur zeitlich überlappende oder angrenzende Pulse zu verändern. Das Pulsmanagement kann zum Beispiel als eigene Hardware ausgeführt oder in die Steuereinheit, insbesondere die Regler integriert werden.

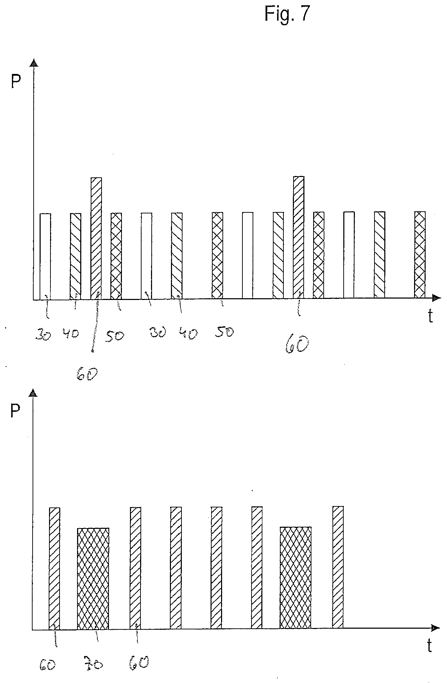

Fig. 7 zeigt nun noch beispielhafte Pulsfolgen, wie sie über die Schalteinheiten 12a, 12b von einem Plasmagenerator gemäß Fig. 3 abgegeben werden, wobei die beiden übereinander angeordneten Darstellungen die Ausgabe an unterschiedlichen Schalteinheiten 12a ,12b des Plasmagenerators zeigen.

Als Leistungsanforderung sollen Pulse 30, 40, 50 mit gleicher Pulsdauer, Periodenlänge zwischen gleichen Pulsen und gleicher Leistung geliefert werden, die zum Beispiel an die drei Plasmaeinheiten 3a bis 3c gehen, in denen zeitgleich gleiche Prozesse ablaufen. Darüber hinaus sollen aber auch Pulse 60 und 70 für die Plasmaeinheiten 3d und 3e mit unterschiedlichen Pulsdauern, Pulsperioden und Leistungen erzeugt werden, wobei jeder Puls 70 zeitlich einen der Pulse 60 überlappt. Die Erfordernisse der die Plasmaeinheiten 3d und 3e lassen keine Verschiebungen zu.

Hier hat die Steuereinheit nun eine Aufteilung der Pulse gefunden bei der die Schalteinheit 12a primär die Pulse 30, 40, 50 ausgibt, während die Schalteinheit 12b primär die Pulse 60 und 70 ausgibt. Da die Schalteinheit 12b jedoch die Pulse 60 und 70 nicht verschieben darf, aber hinsichtlich der Anforderung jedesmal ein Überlapp besteht, wenn der Puls 70 auszugeben ist, wird zu dem Zeitpunkt der Ausgabe des Pulses 70 über die Schalteinheit 12b der erforderliche Puls 60 über die Schalteinheit 12a ausgegeben. Bei der Darstellung gemäß Fig. 7 ist dies ohne eine Verschiebung der Pulse 30, 40 und 50 möglich. Es kann aber sofern erforderlich auch zwischen den Pulsen 30, 40 und/oder 50 Platz geschaffen werden, um den Puls 60 aufzunehmen, sofern die Erfordernisse der Plasmaeinheiten 3a bis 3c dem nicht entgegen stehen.

Wie zu erkennen ist, bietet der Plasmagenerator 5 gemäß Fig. 3 eine große Flexibilität hinsichtlich der Erstellung von Pulsfolgen um die Leistungsanforderungen einer Vielzahl von Plasmaeinheiten unter Berücksichtigung der jeweiligen Erfordernisse zu erfüllen. Nachfolgend werden nun noch weitere spezielle Pulsmanagementvarianten näher erläutert.

## Pulsverschiebung mit Puls-Aus-Zeit-Analyse

Im Folgenden wird das Konzept Pulsverschiebüng mit Puls-Aus-Zeit Analyse vorgestellt, bei dem die Verschiebung eines Pulses gegebenenfalls eine Verschiebung nachfolgender Pulse für die gleiche Kammer zur Folge hat (wobei nachfolgend die Pulse für eine jeweilige Kammer auch als Pulse eines Kanals bezeichnet werden). Dabei gelten folgende Regeln:

a. Pulslänge und Pulshöhe dürfen nicht verändert werden.

b. Pausenzeiten zwischen den Pulsen sind Mindestzeiten, können bei aber Bedarf verlängert werden.

c. Der zuerst angeforderte Puls wird zuerst ausgegeben, der Puls auf dem anderen Kanal muss warten und wird dann vollständig ausgegeben. Die Resultierende Puls-Aus-Zeit Verlängerung (verlängerte Pausenzeit zwischen vorhergehendem Puls und dem verschobenen Puls) wird nicht von der nächsten Puls-Aus-Zeit abgezogen. Mithin werden nachfolgende Pulse um die Puls-Aus-Zeit Verlängerung nach hinten verschoben.

d. Wenn zwei Pulse genau zur gleichen Zeit angefordert werden, wird zuerst der kürzere Puls und dann der längere Puls ausgegeben. Falls diese gleich sind, sollte der Puls auf dem ersten Kanal zuerst ausgegeben werden. Bei mehreren Kanälen in einer definierten Ausgangsreihenfolge.

e. Die Verschiebung der Pulse führt zu einer Erhöhung der Puls-Aus-Zeit über einen Zeitraum. Davon soll ein gleitender Mittelwert gebildet werden. Dieser Wert gibt an wie viel länger die gesamte Puls-Aus-Zeit über die Zeit im Durchschnitt ausfällt. Dies nennen wir im folgenden Puls-Aus-Zeit-Erhöhung.

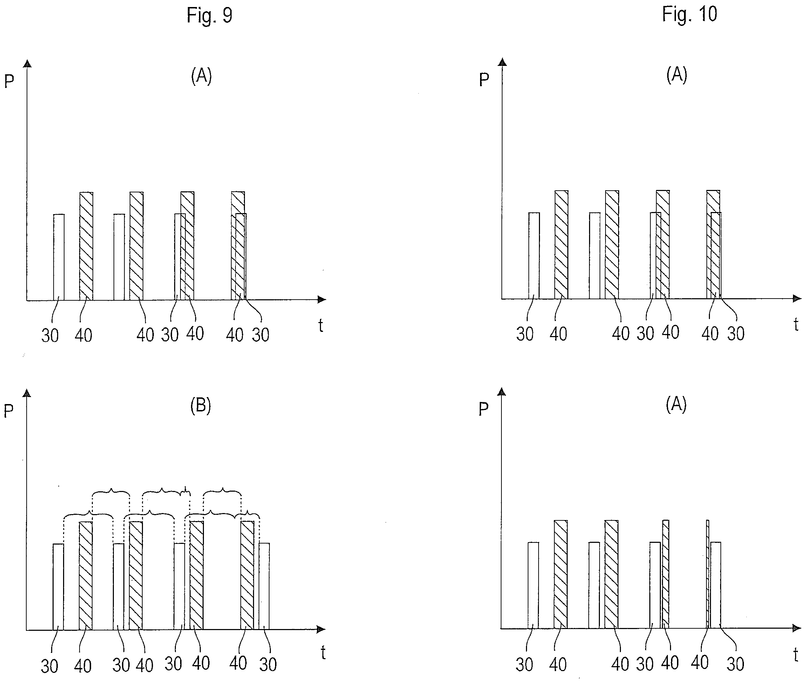

Die Figuren 9(A) und (B) zeigen dieses Konzept anhand eines Systems mit zwei Kammern (Kanälen), wobei Fig. 9(A) eine Pulsanforderung und Fig. 9(B) eine entsprechende Pulsausgabe darstellt. Wie in Fig. 9(A) dargestellt ist, überlappen sich jeweils die dritten und vierten angeforderten Pulse 30 und 40, wobei bei den dritten Pulsen der Puls 30 vor dem Puls 40 anfangen soll und bei den vierten Pulsen der Puls 40 vor dem Puls 30 anfangen soll. Wie in Fig. 9(B) dargestellt ist wird bei den dritten Pulsen daher der Puls 30 zuerst ausgegeben gefolgt durch den Puls 40. Bei den vierten Pulsen wird dann der Puls 40 zuerst ausgegeben gefolgt durch den Puls 30. Dabei wird der vierte Puls 40 aber gegenüber seinem Anforderungsprofil aber um dieselbe Zeit nach hinten geschoben, wie der dritte Puls nach hinten verschoben wurde, damit die Pausenzeit zwischen dem dritten und vierten Puls nicht unter die angeforderte Pausenzeit (Mindestpausenzeit) absinkt. Mithin zieht die Verschiebung eines Pulses eine Verschiebung nachfolgender Pulse nach sich.

Ein Vorteil von diesem Ansatz ist, dass es ist nicht notwendig wird, die resultierende Wartezeit des untergeordneten Pulses von der Pausenzeit abzuziehen. Dies verhindert unerwünschte Rückkopplungen. Jedoch kann dieser Ansatz über die Zeit zu einer Puls-Aus-Zeit-Erhöhung, mithin einer verringerten Leistungsabgabe führen. Um dem entgegenzuwirken sind unterschiedliche Maßnahmen möglich, wie zum Beispiel eine dem gleitenden Mittelwert entsprechende Verlängerung des Gesamtprozesses in den betroffenen Kammern. Weitere beispielhafte Maßnahmen werden nachfolgend erläutert.

## Pulsverschiebung mit Puls-Aus-Zeit-Korrektur

Um für die erhöhten Puls-Aus-Zeit über einen Zeitraum zu kompensieren, können die obigen Regeln aus a. bis e. um folgende Regel ergänzt werden.

f. Der Benutzer muss ein Korrekturwert eingegeben, der die Wartezeit der Pulse um einen fest vorgegeben Wert reduziert. Der Wert wird vom Benutzer basieren auf dem ermittelten gleitenden Mittelwert gewählt und es erfolgt keine Rückkopplung während des Prozesse. Dies ist in folgender Formel dargestellt.

Puls-Aus-Zeit$_{Puls\ X}$ = eingestellte Puls-Aus-Zeit$_{PulsX}$ - Korrekturwert

Wenn der gleitende Mittelwert zum Beispiel im Mittel eine Verlängerung der Puls-Aus-Zeit um 2% ergibt, kann der Korrekturwert entsprechend eingestellt werden. So kann im Fall von 2% zum Beispiel bei einer eingestellten Puls-Aus-Zeit von 50μs ein Korrekturwert von 1μs eingegeben werden. Dieser wird dann fest während des Prozesses verwendet.

**Pulsverschiebung mit Puls-Aus-Zeit-Korrektur**

Ein weiterer Ansatz zur Kompensation der erhöhten Puls-Aus-Zeit über einen Zeitraum ist die Berechnung einen Relativwertes. Dafür können die Regeln a. bis e. um folgende Regel ergänzt werden.

g. Es wird ein Korrekturwert in Prozent eingegeben, der die Pausenzeit zwischen aufeinanderfolgenden Pulsen um einen zufällig verteilten Prozentwert zwischen 0% und dem eingegebenen Korrekturwert reduziert. Zum Beispiel ergibt sich bei 10% für eine eingestellte Puls-Aus-Zeit von 50μs ein Fenster von 45μs bis 50μs für die Pausenzeit. Der Wert wird vom Benutzer gewählt und es erfolgt keine weitere Rückkopplung. Dies ist in folgender Formel dargestellt.

$$\text{Puls-Aus-Zeit}_{\text{Puls X}} = \text{eingestellte Puls-Aus-Zeit}_{\text{Puls X}} * (100\% - X)$$

X ist hierbei ein Zufallswert in % zwischen 0% und dem eingestellten Korrekturwert. Dieser wird während des Prozesses fest eingestellt und verwendet.

**Pulsverschiebung mit Puls-Aus-Zeit-Korrektur mit Rückkopplung**

Ein weiterer alternativer Ansatz zur Kompensation der erhöhten Puls-Aus-Zeit über einen Zeitraum ist eine Kompensation mit Rückkopplung. Um den Plasmagenerator Benutzerfreundlicher zu machen wird der Korrekturwert automatisch ermittelt, eingegeben und durch Integrationen angepasst. Dies kann in manchen Fällen jedoch zu unerwünschten Schwingungen durch Rückkopplung führen. Gegebenenfalls können Algorithmen eingesetzt werden, die solche möglichen Schwingungen vorab erkennen und unterdrücken.

Dafür werden die obigen Regeln a. bis e. um folgende Regel ergänzt.

h. Basierend auf einer ermittelten Puls-Aus-Zeit-Verlängerung wird ein Korrekturwert bestimmt. Die Puls-Aus-Zeit-Verlängerung wird dafür mit einem proportionalen Faktor K multipliziert. K kann vom Benutzer gewählt werden und entspricht für K < 1 einem Dämpfungsfaktor und K > 1 einem Verstärkungsfaktor. Dies ist in folgenden Formeln dargestellt:

$$\text{Korrekturwert} = K * \text{Puls-Aus-Zeit-Verlängerung}$$

$$\text{Puls-Aus-Zeit} = \text{eingestellte Puls-Aus-Zeit} - \text{Korrekturwert}$$

Diese Formeln können für jeden Puls angewandt werden.

**Pulsverschiebung mit Puls-Zeit-Erhaltung**

Der Puls-Zeit-Erhaltungsansatz wird genutzt um Leistungsverluste und aufwändige Korrekturmechanismen, wie oben beschrieben zu umgehen. Hierbei werden folgende Regeln eingesetzt:

a. Pulslänge und Pulshöhe dürfen nicht verändert werden.

b. Pausenzeiten zwischen aufeinanderfolgenden Pulsen eines Kanals sind flexibel und können bei Bedarf verkürzt oder verlängert werden.

c. Der erste angeforderte Puls wird zuerst ausgegeben, der Puls auf dem anderen Kanal wird zeitlich nach hinten verschoben (die Puls-Aus-Zeit zum vorherigen Puls des Kanals wird verlängert) und wird dann vollständig ausgegeben. Entsprechen wird dann die Verlängerung der Puls-Aus-Zeit von der Puls-Aus-Zeit zum nächsten Puls der gleichen Kanals abgezogen sodass der nachfolgende Puls mit einer verkürzten Puls-Aus-Zeit ausgegeben wird.

Mithin wird jeder Puls - soweit nicht eine Überschneidung mit einem Puls eines anderen Kanals vorliegt - zum Anforderungszeitpunkt ausgegeben. Die Verschiebung eines Pulses bedingt keine Verschiebung nachfolgender Pulse des gleichen Kanals.

**Pulsausfall mit Prioritäten**

Ein weiterer Ansatz fürs Pulsmanagement ist das wenigstens teilweise Weglassen von Pulsen indem einem der Pulse Priorität gewährt wird. Hierfür ergeben sich zum Beispiel folgende Regeln:

a. Die Pulshöhe darf nicht verändert werden.
b. Pausenzeiten sind fix und werden nicht verändert.
c. Die ausgegebenen Pulse haben eine Prioritäten Liste und der Wichtige Puls wird immer über dem unwichtigen ausgegeben. Dabei kann der niederpriorisierte Puls komplett verfallen oder nur teilweise Ausgegeben werden
d. Die Summe der ausgefallenen Pulse wird ermittelt und ergibt eine Puls-Ausfall-Summe.

Die Figuren 10(A) und (B) zeigen dieses Konzept anhand eines Systems mit zwei Kammern (Kanälen), wobei Fig. 10(A) eine Pulsanforderung und Fig. 10 (B) eine entsprechende Pulsausgabe darstellt. Wie in Fig. 10(A) dargestellt ist, überlappen sich jeweils die dritten und vierten angeforderten Pulse 30 und 40. Bei dem Beispiel besitzt der Puls 30 die höhere Priorität, sodass dieser immer wie angefordert ausgegeben wird, wie in Fig. 10(B) zu erkennen ist. Die dritten und vierten Pulse 40 werden hingegen verkürzt ausgegeben. Beim dritten Puls 40 wird der Anfang hinter das Ende des Puls 30 gezogen wird, währen das Ende gemäß Anforderungsprofil beibehalten wird. Beim vierten Puls 40 beginnt der Puls wie angefordert, endet aber früher, insbesondere vor dem Anforderungszeitpunkt (und der Aussgabe) des überlappend angeforderten Puls 30.
Der (teilweise) Verfall der Pulse kann den Leistungseintrag deutlich reduzieren, weswegen im Folgenden ein Ansatz definiert ist um diesem Problem entgegenzuwirken.

**Pulsausfall mit Pulsanzahl Korrektur**

Als Alternativer Ansatz um den Effekt (teilweise) ausgefallener Pulse gemäß dem Ansatz "Pulsausfall mit Prioritäten" zu kompensieren können die entsprechenden Regeln a. bis d. um folgende Regel ergänzt werden.
e. Basierend auf der in d. bestimmten Puls-Ausfall-Summe wird die Anzahl der Ausgefallen Puls am Ende Regelpulsfolge ausgegeben.
Da das Prozessergebnis in der Regel stark von der eingebrachten Gesamtleistung abhängig ist, kann zum Beispiel ein Pulsausfall - sofern dieser nicht zum Abbruch des Prozesses führt - durch eine einfache Verlängerung der Prozesszeit kompensiert werden.

**Pulsausfall mit Pulsleistungs-** und/oder Pulsdauerkorrektur

Um der Leistungsreduzierung entgegenzuwirken kann die Pulsdauer und/oder die Pulsleistung variiert werden, wobei eine Pulsdauervariation eine Abweichung zur normal (angeforderten) Pulsdauer beinhaltet, sodass es sich nicht um eine einfache Pulsverschiebung handelt. Hierbei können die Regeln a. bis d. gemäß dem Ansatz "Pulsausfall mit Prioritäten" wie folgt angepasst und durch die folgenden Regeln ergänzt werden:

a. Die Pulshöhe darf nur innerhalb vorgegebener Grenzen verändert werden.

b. Pausenzeiten dürfen gegebenenfalls innerhalb vorgegebener Grenzen verändert, insbesondere verkürzt werden.

c. Die ausgegebenen Pulse haben eine Prioritäten Liste und der Wichtige Puls wird immer über dem unwichtigen ausgegeben. Dabei kann der niederpriorisierte Puls komplett verfallen oder nur teilweise Ausgegeben werden

d. Der Anteil des Pulses der infolge einer Überschneidung ausfällt wird ermittelt.

e. Ermitteln, wie weit der ausfallende Anteil des Pulses unter Berücksichtigung der Pausenzeiten durch eine Verschiebung des Pulsbeginns/des Pulsendes und/oder durch eine Pulserhöhung innerhalb der vorgegebenen Grenzen kompensiert werden kann.

f. Verschieben der Pulsbeginns/des Pulsendes und/oder Erhöhen des Pulses innerhalb der vorgegebenen Grenzen.

Hierbei kann ein zum Beispiel das Verschieben des Pulsbeginns/des Pulsendes gegenüber einer Pulserhöhung prioritär behandelt werden, sodass zunächst versucht wird durch eine Verschiebung den ausfallenden Anteil des Pulses zu kompensieren und erst dann durch eine Pulserhöhung der verbleibende Anteil (sofern vollständig möglich) kompensiert wird. Die Priorität kann aber auch anders herum festgelegt werden oder es kann eine Gewichtung eingestellt werden.

Natürlich kann es auch möglich sein, dass nur ein Verschieben des Pulsbeginns/des Pulsendes oder eine Pulserhöhung zulässig ist.

Die unterschiedlichen obigen Ansätze können soweit kompatibel miteinander kombiniert werden, sodass sich dem Fachmann je nach Prozesserfordernis unterschiedlichste Ansätze ergeben.

Die Erfindung wurde zuvor anhand bevorzugter Ausführungsformen der Erfindung beschrieben, ohne auf die konkreten Ausführungsformen begrenzt zu sein. Insbesondere können die Plasmageneratoren für unterschiedlichste Plasmaeinheiten eingesetzt werden und auch kann die Anzahl der von einem Plasmagenerator zu versorgenden Plasmaeinheiten von der dargestellten Anzahl abweichen. Bei der Ausführungsform gemäß Fig. 3 ist es auch nicht notwendig, dass die Schalteinheiten 12a, 12b jeweils mit allen Plasmaeinheiten 3a bis 3e verbunden sind. So wäre es zum Beispiel auch denkbar, dass nur Plasmaeinheiten 3a bis 3c mit der Schalteinheit 12a verbunden sind und die Plasmaeinheiten 3c bis 3e mit der Schalteinheit 12b, sodass nur die Plasmaeinheiten 3c von beiden angesteuert werden kann. Dies würde die Flexibilität reduzieren, aber immer noch die Versorgung wenigstens einer der Plasmaeinheiten über zwei Schalteinheiten ermöglichen, um mögliche Konflikte bei einer Pulsfolgenerstellung zu lösen.

## Patentansprüche

1. PJasmagenerator (5) zum gepulsten Bereitstellen von elektrischer Leistung mit einer Frequenz von wenigstens 40kHz an wenigstens zwei Prozesskammern, wobei der Plasmagenerator (5) folgendes aufweist:

   eine Steuereinheit (14) die geeignet ist Prozessdaten über Prozesse in den wenigstens zwei Prozesskammern zu erhalten und auszuwerten;
   ein regelbares Netzteil (10) mit einem Ausgang, das geeignet ist ansprechend auf ein Steuersignal von der Steuereinheit (14) an seinem Ausgang einen Gleichstrom mit einer vorbestimmten Spannung und/oder Stärke auszugeben; und
   eine Schalteinheit (12) mit einem ersten Eingang, der mit dem Ausgang des Netzteils (10) verbunden ist, und mit wenigstens zwei Schalteinheitsausgängen zur jeweiligen Verbindung mit einer der wenigstens zwei Prozesskammern;
   wobei die Schalteinheit (12) geeignet ist, aus einem Gleichstrom am Eingang einen Wechselstrom mit einer vorbestimmten Frequenz von wenigstens 40kHz als ein Ausgangssignal zu formen und das Ausgangssignal ansprechend auf ein Steuersignal von der Steuereinheit (14), als einen Puls selektiv für vorbestimmte Pulsdauer an einen der Schalteinheitsausgänge auszugeben;
   wobei die Steuereinheit (14) geeignet ist Leistungsanforderungen der wenigstens zwei Prozesskammern zu koordinieren und das Netzteil (10) und die Schalteinhei (12) derart anzusteuern, dass an den jeweiligen mit den Prozesskammern in Verbindung stehenden Schalteinheitsausgängen jeweils im Wesentlichen die den Leistungsanforderungen entsprechende Leistung über einen Zeitraum als Pulse zur Verfügung gestellt wird, wobei die Pulse der jeweiligen Prozesskammern so zeitlich so zueinander versetzt sind, dass die Prozesskammern zeitgleich betrieben werden können;
   wobei die Schalteinheit (12) wenigstens einen Schalteinheitsausgang aufweist der zur Verbindung mit einem Absorber (20) geeignet ist, und wobei die Schalteinhei (12) geeignet ist ansprechend auf ein eingehendes Steuersignal das Ausgangssignal als Puls selektiv für eine vorbestimmte Pulsdauer an den Schalteinheitsausgang für den Absorber (20) anzulegen.

2. Plasmagenerator (5) zum gepulsten Bereitstellen von elektrischer Leistung mit einer Frequenz von wenigstens 40kHz an wenigstens drei Prozesskammern, wobei der Plasmagenerator (5) folgendes aufweist:

   eine Steuereinheit (14) die geeignet ist Prozessdaten über Prozesse in den wenigstens drei Prozesskammern zu erhalten und auszuwerten;
   ein erstes regelbares Netzteil (10a) mit einem Ausgang, das geeignet ist ansprechend auf ein Steuersignal von der Steuereinheit (14) an seinem Ausgang einen Gleichstrom mit einer vorbestimmten Spannung und/oder Stärke auszugeben;
   ein zweites regelbares Netzteil (10b) mit einem Ausgang, das geeignet ist ansprechend auf ein Steuersignal von der Steuereinheit (14) an seinem Ausgang einen Gleichstrom mit einer vorbestimmten Spannung und/oder Stärke auszugeben;
   eine erste Schalteinheit (12a) mit einem ersten Eingang, der mit dem Ausgang des ersten Netzteils (10a) verbunden ist, und mit wenigstens drei Schalteinheitsausgängen zur jeweiligen Verbindung mit einer der wenigstens drei Prozesskammern;

eine zweite Schalteinheit (12b) mit einem Eingang, der mit dem Ausgang des zweiten Netzteils (10b) verbunden ist, und mit wenigstens drei Schalteinheitsausgängen zur jeweiligen Verbindung mit einer der wenigstens drei Prozesskammern;

wobei die Schalteinheiten (12a, 12b) jeweils geeignet sind, aus einem Gleichstrom am Eingang einen Wechselstrom mit einer vorbestimmten Frequenz von wenigstens 40kHz als ein Ausgangssignal zu formen und das Ausgangssignal ansprechend auf ein Steuersignal von der Steuereinheit (14), als einen Puls selektiv für vorbestimmte Pulsdauer an einen der jeweiligen Schalteinheitsausgänge auszugeben;

wobei die Steuereinheit (14) geeignet ist Leistungsanforderungen der wenigstens drei Prozesskammern zu koordinieren und die Netzteile (10a, 10b) und die ersten und zweiten Schalteinheiten (12a, 12b) derart anzusteuern, dass an den jeweiligen mit den Prozesskammern in Verbindung stehenden Schalteinheitsausgängen jeweils im Wesentlichen die den Leistungsanforderungen entsprechende Leistung über die Zeit hinweg als Pulse zur Verfügung stehen, wobei die durch eine Schalteinheit bereitgestellten Pulse für eine jeweilige der Prozesskammern zeitlich zueinander vefsetzt sind, während sich die Pulse der zwei Schalteinheiten (12a, 12b) jedoch überlappen können.

3. Plasmagenerator (5) nach Anspruch 1 oder 2, wobei die Steuereinheit (14) eine der Anzahl der an die Schalteinheit/en (12, 12a, 12b) anzuschließenden Prozesseinheiten (3a-3e), die jeweils eine der Prozesskammern besitzen, entsprechende Anzahl von Reglern (16a-16e) aufweist, wobei jeder Regler (16a-16e) geeignet ist Prozessdaten über Prozesse in einer jeweiligen der Prozesskammern zu erhalten, wobei jeder Regler (16a-16e) mit dem/den Netzteil/en (10, 10a, 10b) und/oder der/den Schalteinheit/en (12, 12a, 12b) in Verbindung steht um diese ansprechend auf die empfangenen Prozessdaten anzusteuern.

4. Plasmagenerator (5) nach einem der Anspruch 1 bis 3, der ferner wenigstens eine Bogen-Unterdrückungseinheit (18) aufweist, die geeignet ist, aktuelle Prozessdaten über Prozesse in wenigstens drei Prozesskammern und aktuelle Daten des/der Netzteils/e (10, 10a, 10b) und/oder der Schalteinheit/en (12, 12a, 12b) erhalten und in Echtzeit auszuwerten, um einen Überschlag oder einen bevorstehenden Überschlag zu erkennen, wobei die Bogen-Unterdrückungseinheit (18) mit dem/den Netzteil/en (10,10a,10b) und/oder der/den Schalteinheit/en (12, 12a, 12b) in Verbindung steht um diese gegebenenfalls ansprechend auf die Erkennung eines Überschlags oder einen bevorstehenden Überschlags anzusteuern, wobei die Bogen-Unterdrückungseinheit (18) bevorzugt einen Teil der Steuereinheit (14) bildet, und/oder wobei bevorzugt die Regler (16a-16e) und/oder die wenigstens eine Bogen-Unterdrückungseinheit (18) als separate Softwaremodule ausgebildet sind, die auf einem gemeinsamen Prozessor oder auf getrennten Prozessoren des Plasmagenerators ausführbar sind.

5. Plasmagenerator (5) nach einem der vorhergehenden Ansprüche, wobei die Schalteinheit/en (12, 12a, 12b) wenigstens einen vierten Schalteinheitsausgang aufweist/aufweisen, der zur Verbindung mit wenigstens einer weiteren Prozesskammer oder einem Absorber (20) geeignet ist, und/oder wobei die Schalteinheitel (12, 12a, 12b) jeweils wenigstens einen Schalteinheitsausgang aufweisen der zur Verbindung mit einem Absorber (20) geeignet ist, und wobei die Schalteinheiten (12, 12a, 12b) geeignet sind ansprechend auf ein eingehendes Steuersignal das Ausgangssignal als Puls selektiv für eine vorbestimmte Pulsdauer an den Schalteinheitsausgang für den Absorber (20) anzulegen.

6. Plasmagenerator (5) nach einem der vorhergehenden Ansprüche, wobei die Steuereinheit (14) so ausgelegt ist, dass sie die Summe aus Pulsdauer und einer entsprechender Pulspause an den jeweiligen Schalteinheitsausgängen einer Schalteinheit (12, 12a, 12b) so koordiniert, dass die Summe jeweils gleich ist oder an einem der Schalteinheitsausgänge ein Vielfaches der Summe am anderen Schalteinheitsausgang ist, oder die Steuereinheit (14) so ausgelegt ist, dass sie Pulse zeitlich bezüglich der Leistungsanforderungen verschiebt, wenn die Leistungsanforderungen zu einem Überlappen von Pulsen an unterschiedlichen Ausgängen einer jeweiligen Schalteinheit (12, 12a, 12b) führen würde, wobei eine entsprechende zeitliche Verschiebung so gewählt ist, dass der Energieaustrag über die jeweiligen Ausgänge über die Zeit hinweg im Wesentlichen der Leistungsanforderung entspricht, oder die Steuereinheit (14) so ausgelegt ist, dass sie einzelne Pulse bezüglich der Leistungsanforderungen in zwei getrennte Pulse aufteilt und zeitlich verschiebt, wenn die Leistungsanforderungen zu einem Überlappen von Pulsen an unterschiedlichen Ausgängen einer jeweiligen Schalteinheit (14) führen würde, wobei eine entsprechende Aufteilung und zeitliche Verschiebung so gewählt ist, dass der Energieaustrag über die jeweiligen Ausgänge über die Zeit hinweg im Wesentlichen der Leistungsanforderung entspricht.

7. Plasmagenerator (5) nach einem der vorhergehenden Ansprüche, wobei die Steuereinheit (14) so ausgelegt ist, dass sie einzelne Pulse zeitlich bezüglich der Leistungsanforderungen verschiebt, wenn die Leistungsanforderungen zu einem Überlappen von Pulsen an unterschiedlichen Ausgängen einer jeweiligen Schalteinheit (12, 12a, 12b) führen würde, wobei eine entsprechende zeitliche Verschiebung so gewählt ist, dass der Energieaustrag über die jeweiligen Ausgänge über die Zeit hinweg der Leistungsanforderung entspricht, und/oder die Steuereinheit (14) so ausgelegt ist, dass sie wenigstens einen der folgenden Parameter eines Pulses verändern kann: eine Position eines Pulses in einer Pulsfolge, eine Aufteilung eines Pulses in Teilpulse, eine Pulsdauer und eine Amplitude eines Pulses, wenn konkrete Leistungsanforderungen zu einem Überlappen von Pulsen an unterschiedlichen Ausgängen einer jeweiligen Schalteinheit (12, 12a, 12b) führen würden.

8. Plasmagenerator (5) nach Anspruch 1 zum gepulsten Bereitstellen von elektrischer Leistung mit einer Frequenz von wenigstens 40kHz an wenigstens drei Prozesskammern, wobei der Plasmagenerator (5) ferner folgendes aufweist: die Steuereinheit (14) die geeignet ist Prozessdaten über Prozesse in den wenigstens drei Prozesskammern zu erhalten und auszuwerten; ein weiteres regelbares Netzteil (10b) mit einem Ausgang, das geeignet ist ansprechend auf ein Steuersignal von der Steuereinheit (14) an seinem Ausgang einen Gleichstrom mit einer vorbestimmten Spannung und/oder Stärke auszugeben;
und

eine weitere Schalteinheit (12b) mit einem Leistungseingang, der mit dem Ausgang des Netzteils (10b) verbunden ist, und mit wenigstens drei Schalteinheitsausgängen zur jeweiligen Verbindung mit einer der wenigstens drei Prozesskammern; wobei die Schalteinheit (12b) geeignet ist, aus einem Gleichstrom am Eingang einen Wechselstrom mit einer vorbestimmten Frequenz von wenigstens 40KHz als ein Ausgangssignal zu formen und das Ausgangssignal ansprechend auf ein Steuersignal von der Steuereinheit (14) als Puls selektiv für vorbestimmte Pulsdauern an einen der Schalteinheitsausgänge auszugeben; wobei die Steuereinheit (14) geeignet ist Leistungsanforderungen der wenigstens drei Prozesskammern zu koordinieren und die Netzteile (10a, 10b) und die Schalteinheiten (12a, 12b) derart anzusteuern, dass an einem jeweiligen der mit den Prozesskammern in Verbindung stehenden Schalteinheitsausgängen jeweils im Wesentlichen die den Leistungsanforderungen entsprechende Leistung über die Zeit hinweg als Pulse zur Verfügung stehen, wobei die durch eine Schalteinheit (12a, 12b) bereitgestellten Pulse für die Prozesskammern zeitlich zueinander versetzt sind, während sich die Pulse der zwei Schalteinheiten (12a, 12b) jedoch überlappen können.

9. Plasmagenerator nach einem der Ansprüche 2 bis 8, wobei die Netzteile (10a, 10b) unterschiedliche Nennleistungen aufweisen.

10. Plasma-Behandlungsvorrichtung mit wenigstens zwei getrennten Prozesskammern und einem Absorber oder wenigstens drei Prozesskammern, wobei in den Prozesskammern jeweils ein Plasma erzeugt werden kann und einem Plasmagenerator (5) nach einem der vorhergehenden Ansprüche, wobei Prozesskammern jeweils mit einem der Schalteinheitsausgänge der Schalteinheit/en (12, 12a, 12b) verbunden sind und optional der Absorber (20) mit einem der Schalteinheitsausgänge der Schalteinheit/en (12, 12a, 12b) verbunden ist.

11. Verfahren zum gepulsten Bereitstellen von elektrischer Leistung mit einer vorbestimmten Frequenz von wenigstens 140kHz an wenigstens zwei getrennte Prozesskammern, mit folgenden Schritten:

Bereitstellen eines Gleichstroms mit einer vorbestimmten Spannung und/oder Stärke an einem Eingang einer Schalteinheit (12), und zwar ansprechend auf ein Steuersignal von einer Steuereinheit (14);
Formen, aus dem Gleichstrom, eines Wechselstrom-Ausgangssignals mit einer vorbestimmten Frequenz von wenigstens 40kHz in der Schalteinheit (12) und, ansprechend auf ein Steuersignal von der Steuereinheit (14), selektives Ausgeben des Wechselstrom-Ausgangssignals als Puls an einem von wenigstens zwei Schalteinheitsausgängen der Schalteinheit (12), von denen jeder mit einer der wenigstens zwei getrennten Prozesskammern verbunden ist;
wobei die Steuereinheit (14), ansprechend auf Leistungsanforderungen der wenigstens zwei Prozesskammern und ansprechend auf Prozessdaten über Prozesse in den wenigstens zwei Prozesskammern, Steuersignale für das Bereitstellen des Gleichstroms und Steuersignale für selektives Ausgeben des Wechselstrom-Ausgangssignals erzeugt, die so koordiniert sind dass an den jeweiligen der mit den Prozesskammern in Verbindung stehenden Schalteinheitsausgängen jeweils im Wesentlichen die den Leistungsanforderungen entsprechende Leistung über die Zeit hinweg als Pulse zur Verfügung gestellt werden, wobei die Pulse für die Prozesskammern zeitlich zueinander versetzt sind, die Prozesskammern aber zeitgleich betrieben werden;
wobei die Schalteinheit (12) wenigstens drei Schalteinheitsausgängen aufweist, von denen einer mit einem Absorber (20) verbunden ist, der geeignet ist elektrische Leistung aufzunehmen und zu absorbieren, und wobei die Steuereinheit (14) in der Lage ist die Prozesse in den jeweiligen Prozesskammern zu überwachen und das Auftreten oder die Gefahr eines Überschlages in einer der Prozesskammern zu erkennen, und darauf ansprechend das Ausgangssignal über eine Pulsdauer oder wenigstens einen Teil davon statt in eine entsprechende

**EP 3 602 601 B1**

der Prozesskammern in den Absorber (20) umzuleiten.

12. Verfahren zum gepulsten Bereitstellen von elektrischer Leistung mit einer vorbestimmten Frequenz von wenigstens 140kHz an wenigstens drei getrennte Prozesskammern, mit folgenden Schritten:

Bereitstellen eines Gleichstroms mit einer vorbestimmten Spannung und/oder Stärke an einem Eingang einer ersten Schalteinheit (12a), und zwar ansprechend auf ein Steuersignal von einer Steuereinheit (14);
Bereitstellen eines Gleichstroms mit einer vorbestimmten Spannung und/oder Stärke an einem Eingang einer zweiten Schalteinheit (12b), und zwar ansprechend auf ein Steuersignal von der Steuereinheit (14);
Formen, aus dem Gleichstrom, eines Wechselstrom-Ausgangssignals mit einer vorbestimmten Frequenz von wenigstens 140kHz in der ersten Schalteinheit (12a) und ansprechend auf ein Steuersignal von der Steuereinheit (14), selektives Ausgeben des Wechselstrom-Ausgangssignals als Puls an einem von wenigstens drei Schalteinheitsausgängen der ersten Schalteinheit (12a), von denen jeder mit einer der wenigstens drei getrennten Prozesskammern verbunden ist;
Formen, aus dem Gleichstrom, eines Wechselstrom-Ausgangssignals mit einer vorbestimmten Frequenz von wenigstens 140kHz in der zweiten Schalteinhei (12b) und, ansprechend auf ein Steuersignal von der Steuereinheit (14), selektives Ausgeben des Wechselstrom-Ausgangssignals als Puls an einem von wenigstens drei Schalteinheitsausgängen der zweiten Schalteinheit (12b), von denen jeder mit einer der wenigstens drei getrennten Prozesskammern verbunden ist;
wobei die Steuereinheit (14), ansprechend auf Leistungsanforderungen der wenigstens drei Prozesskammern und ansprechend auf Prozessdaten über Prozesse in den wenigstens drei Prozesskammern, Steuersignale für das Bereitstellen des Gleichstroms an den Eingängen der ersten und zweiten Schalteinheiten (12a, 12b) und Steuersignale für selektives Ausgeben der Wechselstrom-Ausgangssignale erzeugt, die so koordiniert sind, dass an den jeweiligen der mit den Prozesskammern in Verbindung stehenden Schalteinheitsausgängen jeweils im Wesentlichen die den Leistungsanforderungen entsprechende Leistung über die Zeit hinweg als Pulse zur Verfügung gestellt werden, wobei die Pulse die durch eine jeweilige der Schalteinheiten (12a, 12b) ausgegebenen werden zeitlich zueinander versetzt sind, die Pulse der beiden Schalteinheiten (12a, 12b) sich aber zeitlich überlappen können.

13. Verfahren nach Anspruch 11 oder 12, wobei die Steuereinheit (14) wenigstens einen der folgenden Parameter eines Pulses verändert: eine Position eines Pulses in einer Pulsfolge, eine Aufteilung eines Pulses in Teilpulse, eine Pulsdauer und eine Amplitude eines Pulses, wenn konkrete Leistungsanforderungen zu einem Überlappen von Pulsen an unterschiedlichen Ausgängen führen würden, wobei die Steuereinheit (14) bevorzugt eine Anpassung nach vorgegebenen festen oder durch einen Bediener einstellbaren Regeln vornimmt, und/oder die Steuereinhei (14) die in Pulsen ausgegebenen Leistung je Prozesskammer über einen Zeitraum hinweg mit der über den Zeitraum hinweg angeforderten Leistung vergleicht und eine Anpassung wenigstens eines Parameters eines Pulses automatisch anhand des Vergleichs erfolgt.

14. Verfahren nach Anspruch 11, wobei die elektrische Leistung an wenigstens drei getrennte Prozesskammern bereit gestellt wird, wobei die Schalteinheit (12, 12a) wenigstens drei Schalteinheitsausgängen aufweist, von denen jeder mit einer der wenigstens drei getrennten Prozesskammern verbunden ist;
und wobei die Steuereinheit (14), ansprechend auf Leistungsanforderungen der wenigstens drei Prozesskammern und ansprechend auf Prozessdaten über Prozesse in den wenigstens drei Prozesskammern, Steuersignale für das Bereitstellen das Gleichstroms und Steuersignale für selektive Ausgeben des Wechselstrom-Ausgangssignals erzeugt, die so koordiniert sind dass an den jeweiligen der mit den Prozesskammern in Verbindung stehenden Schalteinheitsausgängen jeweils die den Leistungsanforderungen entsprechende Leistung über die Zeit hinweg als Pulse zur Verfügung gestellt werden, wobei die Pulse für die Prozesskammern zeitlich zueinander versetzt sind, die Prozesskammern aber zeitgleich betrieben werden, oder
wobei das Verfahren die folgenden weiteren Schritte aufweist:

Bereitstellen eines Gleichstroms mit einer vorbestimmten Spannung und/oder Stärke an einem Eingang einer weiteren Schalteinheit (12b), und zwar ansprechend auf ein Steuersignal von der Steuereinheit (14);
Formen, aus dem Gleichstrom, eines Wechselstrom-Ausgangssignals mit einer vorbestimmten Frequenz von wenigstens 40KHz in der weiteren Schalteinhei (12b) und, ansprechend auf ein Steuersignal von der Steuereinheit (14), selektives Ausgeben des Wechselstrom-Ausgangssignals als Puls mit vorbestimmter Pulsdauer an einem von wenigstens drei Schalteinheitsausgängen der weiteren Schalteinheit (12b), von denen jeder mit einer der wenigstens drei getrennten Prozesskammern verbunden ist;
wobei die Steuereinheit (14), ansprechend auf Leistungsanforderungen der wenigstens drei Prozesskammern und ansprechend auf Prozessdaten über Prozesse in den wenigstens drei Prozesskammern, Steuersignale für das Bereitstellen des Gleichstroms und Steuersignale für selektives Ausgeben des Wechselstrom-Ausgangssignals erzeugt, die so koordiniert sind dass an den jeweiligen der mit den Prozesskammern in Verbindung stehenden Schalteinheitsausgängen jeweils im Wesentlichen die den Leistungsanforderungen entsprechende Leistung über die Zeit hinweg als Pulse mit vorbestimmter Pulsdauer zur Verfügung gestellt wird, wobei die Pulse die durch eine der Schalteinheiten (12a, 12b) ausgegebenen werden zeitlich zueinander versetzt sind, die Pulse der beiden Schalteinheiten (12a, 12b) sich aber zeitlich überlappen können.

15. Verfahren nach einem der Ansprüche 12 bis 14, wobei die Schalteinheiten (12a, 12b) wenigstens einen Schalteinheitsausgang aufweisen, der mit einem Absorber (20) verbunden ist, der geeignet ist elektrische Leistung aufzunehmen und zu absorbieren, und wobei die Steuereinheit (14) in der Lage ist die Prozesse in den jeweiligen Prozesskammern zu überwachen und das Auftreten oder die Gefahr eines Überschlages in einer der Prozesskammern zu erkennen, und darauf ansprechend das Ausgangssignal über eine Pulsdauer oder wenigstens einen Teil davon statt in eine entsprechende der Prozesskammern in den Absorber (20) umzuleiten.

## Claims

1. A plasma generator (5) for the pulsed provision of electrical power having a frequency of at least 40 kHz to at least two process chambers, the plasma generator (5) comprising:

   a control unit (14) configured to obtain and evaluate process data about processes in the at least two process chambers;
   a controllable power supply (10) having an output, the controllable power supply configured to output a direct current having a predetermined voltage and/or intensity at its output in response to a control signal from the control unit (14); and
   a switching unit (12) having a first input connected to the output of the power supply (10), and having at least two switching unit outputs for respective connection to one of the at least two process chambers;
   wherein the switching unit (12) is configured to form from a direct current at the input an alternating current having a predetermined frequency of at least 40 kHz as an output signal and to selectively output the output signal as a pulse for a predetermined pulse duration to one of the switching unit outputs in response to a control signal from the control unit (14);
   wherein the control unit (14) is configured to coordinate power requirements of the at least two process chambers and to drive the power supply (10) and the switching unit (12) such that at the respective switching unit outputs communicating with the process chambers, substantially the power corresponding to the respective power requirements is provided as pulses over a period of time, wherein the pulses of the respective process chambers are temporally offset from each other such that the process chambers can be operated simultaneously; and
   wherein the switching unit (12) has at least one switching unit output configured for connection to an absorber (20), and wherein the switching unit (12) is configured to, in response to an incoming control signal, selectively apply the output signal as a pulse to the switching unit output for the absorber (20) for a predetermined pulse duration.

2. A plasma generator (5) for the pulsed provision of electrical power having a frequency of at least 40 kHz to at least three process chambers, the plasma generator (5) comprising:

   a control unit (14) configured to obtain and evaluate process data about processes in the at least three process chambers;
   a first controllable power supply (10a) having an output, the first controllable power supply configured to output a direct current having a predetermined voltage and/or intensity at its output in response to a control signal from the control unit (14);
   a second controllable power supply (10b) having an output, the second controllable power supply configured to output a direct current having a predetermined voltage and/or intensity at its output in response to a control signal from the control unit (14);
   a first switching unit (12a) having an input connected to the output of the first power supply (10a), and having at least three switching unit outputs for respective connection to one of the at least three process chambers;
   a second switching unit (12b) having an input connected to the output of the second power supply (10b), and having at least three switching unit outputs for respective connection to one of the at least three process chambers;

wherein the switching units (12a, 12b) are each configured to form from a direct current at the input an alternating current having a predetermined frequency of at least 40 kHz as an output signal and to selectively output the output signal as a pulse for a predetermined pulse duration to a respective one of the switching unit outputs in response to a control signal from the control unit (14);

wherein the control unit (14) is configured to coordinate power requirements of the at least three process chambers and to drive the power supplies (10a, 10b) and the first and second switching units (12a, 12b) such that at the respective switching unit outputs communicating with the process chambers, substantially the power corresponding to the respective power requirements is provided as pulses over time, wherein the pulses provided by one of the switching units for respective ones of the process chambers are temporally offset from each other, while the pulses of the two switching units (12a, 12b) may overlap.

3. The plasma generator (5) according to claim 1 or 2, wherein the control unit (14) has a number of controllers (16a - 16e) corresponding to the number of process units (3a - 3e), each having a process chamber, to be connected to the switching unit/s (12, 12a, 12b), each controller (16a - 16e) being configured to obtain process data on processes in a respective one of the process chambers, each controller (16a - 16e) being connected to the power supply/supplies (10, 10a, 10b) and/or the switch unit/s (12, 12a, 12b) to drive the same in response to the received process data.

4. The plasma generator (5) according to any one of claims 1 to 3, further comprising at least one arc suppression unit (18) configured to obtain and evaluate in real time current process data on processes in the at least three process chambers and current data of the power supply/supplies (10, 10a, 10b) and/or the switch unit/s (12, 12a, 12b) to detect an arc or an impending arc, wherein the arc suppression unit (18) is in communication with the power supply/supplies (10, 10a, 10b) and/or the switch unit/s (12, 12a, 12b) to drive the same, if needed, in response to the detection of an arc or an impending arc, wherein the arc suppression unit (18) preferably forms part of the control unit (14), and/or wherein the controllers (16a - 16e) and/or the at least one arc suppression unit (18) are formed as separate software modules executable on a common processor or on separate processors of the plasma generator.

5. The plasma generator (5) according to any one of the preceding claims, wherein the switching unit/s (12, 12a, 12b) has/have at least one fourth switching unit output configured for connection to at least one further process chamber or an absorber (20), and/or wherein the switching units (12, 12a, 12b) each have at least one switching unit output configured for connection to an absorber (20), and wherein the switching units (12, 12a, 12b) are configured to, in response to an incoming control signal, selectively apply the output signal as a pulse to the switching unit output for the absorber (20) for a predetermined pulse duration.

6. The plasma generator (5) according to any one of the preceding claims, wherein the control unit (14) is configured to coordinate the sum of pulse duration and a corresponding pulse pause at the respective switching unit outputs of one switching unit (12, 12a, 12b) such that the sum is equal for each in each switching unit output or that the sum at one of the switching unit outputs is a multiple of the sum at another switching unit output., or
wherein the control unit (14) is configured to shift pulses in time with respect to the power requirements if the power requirements would lead to an overlapping of pulses at different outputs of a respective switching unit (12, 12a, 12b), wherein a respective time shift is selected such that the energy output at the respective outputs essentially corresponds to the power requirement over time, or
wherein the control unit (14) is configured to split individual pulses into two separate pulses with respect to the power requirements and to shift them in time if the power requirements would result in overlapping of pulses at different outputs of a respective switching unit (14), wherein a respective splitting of the pulse and a respective time shift are selected such that the energy output at the respective outputs essentially corresponds to the power requirement over time.

7. The plasma generator (5) according to any one of the preceding claims, wherein the control unit (14) is configured to shift individual pulses in time with respect to the power requirements if the power requirements would lead to overlapping of pulses at different outputs of a respective switching unit (12, 12a, 12b), wherein a respective shift in time is selected such that the energy output at the respective outputs essentially corresponds to the power requirement over time, and/or
wherein the control unit (14) is configured to vary at least one of the following parameters of a pulse: a position of a pulse in a pulse sequence, a division of a pulse into partial pulses, a pulse duration, and an amplitude of a pulse when actual power requirements would lead to overlapping of pulses at different outputs of a respective switching unit (12, 12a, 12b).

8. The plasma generator (5) according to claim 1 for the pulsed provision of electrical power at a frequency of at least 40 kHz to at least three process chambers, the plasma generator (5) further comprising:

the control unit (14) configured to obtain and evaluate process data about processes in the at least three process chambers;

an additional controllable power supply (10b) having an output, the controllable power supply being configured to output a direct current having a predetermined voltage and/or intensity at its output in response to a control signal from the control unit (14); and

an additional switching unit (12b) having a power input connected to the output of the additional power supply (10b) and having at least three switching unit outputs for respective connection to one of the at least three process chambers;

wherein the switching unit (12b) is configured to form from a direct current at the input an alternating current having a predetermined frequency of at least 40 kHz as an output signal and to selectively output the output signal as a pulse having a predetermined pulse duration to one of the switching unit outputs in response to a control signal from the control unit (14);

wherein the control unit (14) is configured to coordinate power requirements of the at least three process chambers and to drive the power supplies (10a, 10b) and the switching units (12a, 12b) such that at a respective one of the switching unit outputs,

communicating with the process chambers, the respective power corresponding to the power requirements is in substance available as pulses over time, wherein the pulses provided by one switching unit (12a, 12b) for the process chambers are temporally offset from each other, while the pulses of the two switching units (12a, 12b) may overlap.

9. The plasma generator according to any one of claims 2 to 8, wherein the power supplies (10a, 10b) have different rated powers.

10. A plasma treatment apparatus comprising at least two separate process chambers and one absorber or at least three process chambers, wherein in each process chamber a plasma can be generated and a plasma generator (5) according to one of the preceding claims, wherein the process chambers are each connected to one of the switching unit outputs of the switching unit/s (12, 12a, 12b) and wherein optionally the absorber is connected to one of the switching unit outputs of the switching unit/s (12, 12a, 12b).

11. A method for the pulsed provision of electrical power having a predetermined frequency of at least 40 kHz to at least two separate process chambers, the method comprising the steps of:

providing a direct current having a predetermined voltage and/or intensity at an input of a switching unit (12) in response to a control signal from a control unit (14);

forming, from the direct current, an alternating current output signal having a predetermined frequency of at least 40 kHz in the switching unit (12) and, in response to a control signal from the control unit (14), selectively outputting the alternating current output signal as a pulse at one of at least two switching unit outputs of the switching unit (12), each of which is connected to one of the at least two separate process chambers;

wherein the control unit (14) generates control signals for providing the direct current and control signals for selectively outputting the alternating current output signal in response to power requirements of the at least two process chambers and in response to process data about processes in the at least two process chambers, wherein the control signals are coordinated such that at the respective switching unit outputs, which are connected to the process chambers, in substance the power corresponding to the power requirements is made available as pulses over time, and the pulses for the process chambers are temporally offset with respect to each other, while the process chambers are operated simultaneously;

wherein the switching unit (12) has at least three switching unit outputs, one of which is connected to an absorber (20) configured to receive and absorb electrical power, and wherein the control unit (14) is configured to monitor the processes in the respective process chambers and to detect the occurrence or risk of arcing or an arc event in one of the process chambers, and in response thereto redirect the output signal into the absorber (20) over a pulse duration or at least a portion thereof rather than into a corresponding one of the process chambers.

12. A method for the pulsed provision of electrical power having a predetermined frequency of at least 40 kHz to at least three separate process chambers, the method comprising the steps of:

providing a direct current having a predetermined voltage and/or intensity at an input of a first switching unit (12a) in response to a control signal from a control unit (14);

providing a direct current having a predetermined voltage and/or intensity at an input of a second switching unit (12b) in response to a control signal from the control unit (14);

forming, from the direct current, an alternating current output signal having a predetermined frequency of at least 40 kHz in the first switching unit (12a) and, in response to a control signal from the control unit (14), selectively outputting the alternating current output signal as a pulse at one of at least three switching unit outputs of the first switching unit (12a), each of which is connected to one of the at least three separate process chambers;

forming, from the direct current, an alternating current output signal having a predetermined frequency of at least 40 kHz in the second switching unit (12b) and, in response to a control signal from the control unit (14), selectively outputting the alternating current output signal as a pulse at one of at least three switching unit outputs of the second switching unit (12b), each of which is connected to one of the at least three separate process chambers;

wherein the control unit (14), in response to power requirements of the at least three process chambers and in response to process data about processes in the at least three process chambers, generates control signals for providing the direct current at the first and second switching units (12a, 12b) and control signals for selectively outputting the alternating current output signals, wherein the control signals are coordinated such that at the respective switching unit outputs, which are connected to the process chambers, in substance the power corresponding to the power requirements is made available as pulses over time, wherein the pulses which are output by a respective one of the switching units (12a, 12b) are offset in time with respect to each other, while the pulses of the two switching units (12a, 12b) may overlap in time.

13. The method according to claim 11 or 12, wherein the control unit changes at least one of the following parameters of a pulse: a position of a pulse in a pulse sequence, a division of a pulse into partial pulses, a pulse duration and an amplitude of a pulse, if actual power requirements would lead to an overlapping of pulses at different outputs, wherein the control unit (14) preferably makes changes according to predetermined fixed rules or rules adjustable by an operator, and/or

wherein the control unit compares the power output in pulses per process chamber over a period of time with the power requested over the period of time and automatically changes at least one parameter of a pulse on the basis of the comparison.

14. The method according to claim 11, wherein the electrical power is provided to at least three separate process chambers, wherein the switching unit (12a, 12b) has at least three switching unit outputs, each connected to one of the at least three separate process chambers;

and wherein the control unit (14), in response to power requirements of the at least three process chambers and in response to process data about processes in the at least three process chambers, generates control signals for providing the direct current and control signals for selectively outputting the alternating current output signal, wherein the control signals are coordinated such that at the respective switching outputs, which are connected to the process chambers, the power corresponding to the power requirements is in substance made available as pulses over time, wherein the pulses for the process chambers are temporally offset from each other, while the process chambers are operated simultaneously, or

wherein the method comprises the following further steps:

providing a direct current having a predetermined voltage and/or intensity at an input of an additional switching unit (12b) in response to a control signal from the control unit (14);

forming, from the direct current, an alternating current output signal having a predetermined frequency of at least 40 kHz in the additional switching unit (12b) and, in response to a control signal from the control unit (14), selectively outputting the alternating current output signal as a pulse having a predetermined pulse duration at one of at least three switching unit outputs of the additional switching unit (12b), each of which is connected to one of the at least three separate process chambers;

wherein the control unit (14), in response to power requirements of the at least three process chambers and in response to process data about processes in the at least three process chambers, generates control signals for providing the direct current and control signals for selectively outputting the alternating current output signal, wherein the control signals are coordinated such that at the respective switching unit outputs, which are connected to the process chambers, in substance the power corresponding to the power requirements is made available over time as pulses of a predetermined pulse duration,

wherein the pulses which are output by one of the switching units (12a, 12b) are offset in time with respect to each other, while the pulses of the two switching units (12a, 12b) may overlap in time.

**15.** The method according to any one of claims 12 to 14, wherein the switching units (12a, 12b) have at least one switching unit output connected to an absorber (20), wherein the absorber is configured to receive and absorb electrical power, and wherein the control unit (14) is configured to monitor the processes in the respective process chambers and to detect the occurrence or risk of arcing or an arc event in one of the process chambers, and in response thereto redirect the output signal into the absorber (20), over a pulse duration or at least a portion thereof, rather than into a corresponding one of the process chambers.

**Revendications**

**1.** Générateur de plasma (5) destiné à la fourniture sous forme pulsée d'une alimentation électrique ayant une fréquence d'au moins 40 kHz à au moins deux chambres de traitement, le générateur de plasma (5) comprenant :

une unité de commande (14) configurée pour obtenir et évaluer des données de traitement concernant des traitements dans lesdites au moins deux chambres de traitement ;
une alimentation commandable (10) ayant une sortie, l'alimentation commandable étant configurée pour fournir un signal continu ayant une tension et/ou une intensité prédéterminées au niveau de sa sortie en réponse à un signal de commande provenant de l'unité de commande (14) ; et
une unité de commutation (12) ayant une première entrée, connectée à la sortie de l'alimentation (10), et ayant au moins deux sorties d'unité de commutation destinées à une connexion respective à une desdites au moins deux chambres de traitement ;
dans lequel l'unité de commutation (12) est configurée pour former, à partir d'un signal continu au niveau de l'entrée, un signal alternatif ayant une fréquence prédéterminée d'au moins 40 kHz sous forme d'un signal de sortie et pour fournir sélectivement le signal de sortie sous forme d'une impulsion pendant une durée d'impulsion prédéterminée à une des sorties de l'unité de commutation en réponse à un signal de commande provenant de l'unité de commande (14) ;
dans lequel l'unité de commande (14) est configurée pour coordonner des besoins en alimentation desdites au moins deux chambres de traitement et pour commander l'alimentation (10) et l'unité de commutation (12) de sorte que, au niveau des sorties des unités de commutation respectives communiquant avec les chambres de traitement, essentiellement l'alimentation correspondant aux besoins en alimentation respectifs est fournie sous forme d'impulsions pendant une période de temps, dans lequel les impulsions des chambres de traitement respectives sont décalées dans le temps les unes par rapport aux autres de sorte que les chambres de traitement peuvent fonctionner simultanément ; et
dans lequel l'unité de commutation (12) a au moins une sortie d'unité de commutation configurée pour être connectée à un absorbeur (20), et dans lequel l'unité de commutation (12) est configurée pour, en réponse à un signal de commande entrant, appliquer sélectivement le signal de sortie sous forme d'une impulsion à la sortie d'unité de commutation pour l'absorbeur (20) pendant une durée d'impulsion prédéterminée.

**2.** Générateur de plasma (5) destiné à la fourniture sous forme pulsée d'une alimentation électrique ayant une fréquence d'au moins 40 kHz à au moins trois chambres de traitement, le générateur de plasma (5) comprenant :

une unité de commande (14) configurée pour obtenir et évaluer des données de traitement concernant des traitements dans lesdites au moins trois chambres de traitement ;
une première alimentation commandable (10a) ayant une sortie, la première alimentation commandable étant configurée pour fournir un signal continu ayant une tension et/ou une intensité prédéterminées au niveau de sa sortie en réponse à un signal de commande provenant de l'unité de commande (14) ;
une deuxième alimentation commandable (10b) ayant une sortie, la deuxième alimentation commandable étant configurée pour fournir un signal continu ayant une tension et/ou une intensité prédéterminées au niveau de sa sortie en réponse à un signal de commande provenant de l'unité de commande (14) ;
une première unité de commutation (12a) ayant une entrée connectée à la sortie de première alimentation (10a), et ayant au moins trois sorties d'unité de commutation destinées à la connexion respective à une desdites au moins trois chambres de traitement ;
une deuxième unité de commutation (12b) ayant une entrée connectée à la sortie de la deuxième alimentation (10b), et ayant au moins trois sorties d'unité de commutation destinées à une connexion respective à une desdites au moins trois chambres de traitement ;
dans lequel les unités de commutation (12a, 12b) sont configurées chacune pour former, à partir d'un signal continu au niveau de l'entrée, un signal alternatif ayant une fréquence prédéterminée d'au moins 40 kHz sous forme d'un signal de sortie et pour fournir sélectivement le signal de sortie sous forme d'une impulsion pendant une durée d'impulsion prédéterminée à une sortie respective parmi les sorties de l'unité de commutation en réponse à un signal de commande provenant de l'unité de commande (14) ;

dans lequel l'unité de commande (14) est configurée pour coordonner des besoins en alimentation desdites au moins trois chambres de traitement et pour commander les alimentations (10a, 10b) et les première et deuxième unités de commutation (12a, 12b) de sorte que, au niveau des sorties des unités de commutation respectives communiquant avec les chambres de traitement, essentiellement l'alimentation correspondant aux besoins en alimentation respectifs est fournie sous forme d'impulsions au cours du temps, dans lequel les impulsions fournies par une des unités de communication à des chambres respectives parmi les chambres de traitement sont temporairement décalées les unes par rapport aux autres, lorsque les impulsions des deux unités de communication (12a, 12b) risquent de se chevaucher.

3.  Générateur de plasma (5) selon la revendication 1 ou 2, dans lequel l'unité de commande (14) a un certain nombre de contrôleurs (16a - 16e) correspondant au nombre d'unités de traitement (3a-3e), ayant chacune une chambre de traitement, à connecter à l'unité / aux unités de commutation (12, 12a, 12b), chaque contrôleur (16a - 16e) étant configuré pour obtenir des données de traitement concernant des traitement dans une chambre respective parmi les chambres de traitement, chaque contrôleur (16a - 16e) étant connecté à l'alimentation/aux alimentations (10, 10a, 10b) et/ou à l'unité/aux unités de commutation pour commander celles-ci en réponse aux données de traitement reçues.

4.  Générateur de plasma (5) selon l'une quelconque des revendications 1 à 3, comprenant en outre au moins une unité de suppression d'arc (18) configurée pour obtenir et évaluer en temps réel des données de traitement courantes concernant des traitements dans lesdites au moins trois chambres de traitement et des données courantes concernant l'alimentation/les alimentations (10, 10a, 10b) et/ou l'unité/les unités de commutation (12, 12a, 12b) pour détecter un arc ou un arc imminent, dans lequel l'unité de suppression d'arc (18) est en communication avec l'alimentation/les alimentations (10, 10a, 10b) et/ou l'unité/les unités de commutation (12, 12a, 12b) pour commander celles-ci, si besoin, en réponse à la détection d'un arc ou d'un arc imminent,

dans lequel l'unité de suppression d'arc (18) constitue de préférence une partie de l'unité de commande (14), et/ou dans lequel les contrôleurs (16a - 16e) et/ou ladite au moins une unité de suppression d'arc (18) sont formés sous forme de modules logiciels séparés exécutables sur un processeur commun ou sur des processeurs séparés du générateur de plasma.

5.  Générateur de plasma (5) selon l'une quelconque des revendications précédentes, dans lequel l'unité/les unités de commutation (12, 12a, 12b) a/ont au moins une quatrième sortie d'unité de commutation configurée pour se connecter à au moins une chambre de traitement supplémentaire ou à un absorbeur (20) et/ou dans lequel les unités de commutation (12, 12a, 12b) ont chacune au moins une sortie d'unité de commutation configurée pour se connecter à un absorbeur (20), et dans lequel les unités de commutation (12, 12a, 12b) sont configurées pour, en réponse à un signal de commande entrant, appliquer sélectivement le signal de sortie sous forme d'une impulsion à la sortie d'unité de commutation pour l'absorbeur (20) pendant une durée d'impulsion prédéterminée.

6.  Générateur de plasma (5) selon l'une quelconque des revendications précédentes, dans lequel l'unité de commande (14) est configurée pour coordonner la somme de la durée d'impulsion et d'une pause d'impulsion correspondante au niveau des sorties d'unité de commutation respective d'une unité de commutation (12, 12a, 12b) de sorte que la somme soit égale pour chacune dans chaque sortie d'unité de commutation ou que la somme au niveau d'une des sorties d'unité de commutation soit un multiple de la somme au niveau d'une autre sortie d'unité de commutation, ou

dans lequel l'unité de commande (14) est configurée pour décaler les impulsions dans le temps par rapport aux besoins en alimentation dans le cas où les besoins en alimentation conduiraient à un chevauchement d'impulsions au niveau de différentes sorties d'une unité de commutation respective (12, 12a, 12b), dans lequel un décalage temporel respectif est sélectionné de telle sorte que la sortie d'énergie au niveau des sorties respectives corresponde essentiellement au besoin en alimentation dans le temps, ou

dans lequel l'unité de commande (14) est configurée pour diviser des impulsions individuelles en deux impulsions séparées par rapport aux besoins en alimentation et les décale dans le temps dans le cas où les besoins en alimentation résulteraient en un chevauchement d'impulsions au niveau de différentes sorties d'une unité de commutation respective (14), dans lequel une division respective de l'impulsion et un décalage temporel respectif sont sélectionnés de sorte que la sortie d'énergie au niveau des sorties respectives corresponde essentiellement aux besoins en alimentation dans le temps.

7.  Générateur de plasma (5) selon l'une quelconque des revendications précédentes, dans lequel l'unité de commande (14) est configurée pour décaler des impulsions individuelles dans le temps par rapport aux besoins en alimentation dans le cas où les besoins en alimentation conduiraient à un chevauchement d'impulsions au niveau de différentes sorties d'une unité de commutation respective (12, 12a, 12b), dans lequel un décalage temporel respectif est sélectionné de sorte que la sortie d'énergie au niveau des sorties respectives corresponde sensiblement aux besoins en alimentation dans le temps, et/ou

dans lequel l'unité de commande (14) est configurée pour modifier au moins un des paramètres suivants d'une impulsion : une position d'une impulsion dans une séquence d'impulsions, une division d'une impulsion en impulsions partielles, une durée d'impulsion, et une amplitude d'une impulsion dans le cas où les besoins en alimentation conduiraient à un chevauchement d'impulsions au niveau de différentes sorties d'une unité de commutation respective (12, 12a, 12b).

8. Générateur de plasma (5) selon la revendication 1 destiné à la fourniture sous forme pulsée d'une alimentation électrique à une fréquence d'au moins 40 kHz à au moins trois chambres de traitement, le générateur de plasma (5) comprenant en outre :

l'unité de commande (14) configurée pour obtenir et évaluer des données de traitement concernant des traitements dans lesdites au moins trois chambres de traitement ;

une alimentation commandable supplémentaire (10b) ayant une sortie, l'alimentation commandable étant configurée pour fournir un signal continu ayant une tension et/ou une intensité prédéterminées au niveau de sa sortie en réponse à un signal de commande provenant de l'unité de commande (14) ; et

une unité de commutation supplémentaire (12b) ayant une entrée d'alimentation connectée à la sortie de l'alimentation supplémentaire (10b) et ayant au moins trois sorties d'unité de commutation pour la connexion respective à une desdites au moins trois chambres de traitement ;

dans lequel l'unité de commutation (12b) est configurée pour former, à partir d'un signal continu au niveau de l'entrée, un signal alternatif ayant une fréquence prédéterminée d'au moins 40 kHz sous la forme d'un signal de sortie et pour fournir sélectivement le signal de sortie sous forme d'une impulsion ayant une durée d'impulsion prédéterminée à une des sorties d'unité de commutation en réponse à un signal de commande provenant de l'unité de commande (14) ;

dans lequel l'unité de commande (14) est configurée pour coordonner des besoins en alimentation desdites au moins trois chambres de traitement et pour commander les alimentations (10a, 10b) et les unités de commutation (12a, 12b) de sorte qu'une respective des sorties de l'unité de commutation, communiquant avec les chambres de traitement, l'alimentation respective correspondant aux besoins en alimentation est sensiblement disponible sous forme d'impulsions sur le temps, dans lequel les impulsions fournies par une unité de commutation (12a, 12b) pour les chambres de traitement sont décalés dans le temps les unes par rapport aux autres, lorsque les impulsions des deux unités de commutation (12a, 12b) risquent de se chevaucher.

9. Générateur de plasma selon l'une quelconque des revendications 2 à 8, dans lequel les alimentations (10a, 10b) ont des niveaux nominaux différents.

10. Appareil de traitement au plasma comprenant au moins deux chambres de traitement séparées et un absorbeur, ou au moins trois chambres de traitement, dans lequel dans chacune des chambres de traitement un plasma peut être généré, et un générateur de plasma (5) selon l'une quelconque des revendications précédentes, dans lequel les chambres de traitement sont chacune connectées à une des sorties d'unité de commutation de l'unité/des unités de commutation (12, 12a, 12b) et dans lequel optionnellement l'absorbeur est connecté à une des sorties d'unité de commutation de l'unité/des unités de commutation (12, 12a, 12b) .

11. Procédé destiné à fournir sous forme pulsée une alimentation électrique ayant une fréquence prédéterminée d'au moins 40 kHz à au moins deux chambres de traitement séparées, le procédé comprenant les étapes de :

fourniture d'un signal continu ayant une tension et/ou une intensité prédéterminées au niveau d'une entrée d'une unité de commutation (12) en réponse à un signal de commande provenant d'une unité de commande (14) ;

formation, à partir du signal continu, d'un signal de sortie alternatif ayant une fréquence prédéterminée d'au moins 40 kHz dans l'unité de commutation (12) et, en réponse à un signal de commande provenant de l'unité de commande (14), la fourniture sélective du signal de sortie alternatif sous forme d'une impulsion au niveau d'une desdites au moins deux sorties de l'unité de commutation de l'unité de commutation (12), dont chacune est connectée à une desdites au moins deux chambres de traitement séparées ;

dans lequel l'unité de commande (14) génère des signaux de commande pour fournir le signal continu et des signaux de commande pour fournir sélectivement le signal de sortie alternatif en réponse à des besoins en alimentation desdites au moins deux chambres de traitement en réponse aux données de traitement concernant des traitements dans lesdites au moins deux chambres de traitement, dans lequel les signaux de commande sont coordonnés de sorte qu'au niveau des sorties d'unité de commutation respectives, qui sont connectées aux chambres de traitement, sensiblement l'alimentation correspondant aux besoins en alimentation est rendue disponible sous forme d'impulsions sur le temps, et les impulsions pour les chambres de traitement sont décalées dans le temps les unes par rapport aux autres, pendant que les chambres de traitement fonctionnent simultanément ;

dans lequel l'unité de commutation (12) a au moins trois sorties d'unité de commutation, dont une est connectée à un absorbeur (20) configuré pour recevoir et absorber une alimentation électrique, et dans lequel l'unité de commande (14) est configurée pour surveiller les traitements dans les chambres de traitement respectives et pour détecter l'apparition ou un risque d'arc ou une occurrence d'un arc dans une des chambres de traitement, et en réponse à cela rediriger le signal de sortie dans l'absorbeur (20) sur une durée d'impulsions ou au moins une partie de celle-ci plutôt que dans une chambre correspondante parmi les chambres de traitement.

12. Procédé destiné à fournir sous forme pulsée une alimentation électrique ayant une fréquence prédéterminée d'au moins 40 kHz à au moins trois chambres de traitement séparées, le procédé comprenant les étapes de :

fourniture d'un signal continu ayant une tension prédéterminée et/ou une intensité prédéterminées au niveau d'une entrée d'une première unité de commutation (12a) en réponse à un signal de commande provenant d'une unité de commande (14) ;

fourniture d'un signal continu ayant une tension et/ou une intensité prédéterminées au niveau d'une entrée d'une deuxième unité de commutation (12b) en réponse à un signal de commande provenant d'une unité de commande (14) ;

formation, à partir du signal continu, d'un signal de sortie alternatif ayant une fréquence prédéterminée d'au moins 40 kHz dans la première unité de commutation (12a) et, en réponse à un signal de commande provenant de l'unité de commande (14), la fourniture sélective du signal de sortie alternatif sous forme d'une impulsion au niveau d'une desdites au moins trois sorties d'unité de commutation de la première unité de commutation (12a), dont chacune est connectée à une desdites au moins trois chambres de traitement séparées ;

formation, à partir du signal continu, d'un signal de sortie alternatif ayant une fréquence prédéterminée d'au moins 40 kHz dans la deuxième unité de commutation (12b) et, en réponse à un signal de commande provenant de l'unité de commande (14), la fourniture sélective du signal de sortie alternatif sous forme d'une impulsion au niveau d'une desdites au moins trois sorties d'unité de commutation de la deuxième unité de commutation (12b), dont chacune est connectée à une desdites au moins trois chambres de traitement séparées ;

dans lequel l'unité de commande (14), en réponse aux besoins en alimentation desdites au moins trois chambres de traitement et en réponse aux données de traitement concernant des traitements dans lesdites au moins trois chambres de traitement, génère des signaux de commande pour fournir le signal continu au niveau des première et deuxième unités de commutation (12a, 12b) et des signaux de commande pour fournir sélectivement les signaux de sortie alternatif, dans lequel les signaux de commande sont coordonnés de sorte que, au niveau des sorties des unités de commutation respectives, qui sont connectées aux chambres de traitement, sensiblement l'alimentation correspondant aux besoins en alimentation est rendue disponible sous forme d'impulsions sur le temps, dans lequel les impulsions qui sont fournies par une respective des unités de commutation (12a, 12b) sont décalées dans le temps les unes par rapport aux autres, lorsque les impulsions des deux unités de commutation (12a, 12b) risquent de se chevaucher dans le temps.

13. Procédé selon la revendication 11 ou 12, dans lequel l'unité de commande modifie au moins un des paramètres suivants d'une impulsion : une position d'une impulsion dans une séquence d'impulsions, une division d'une impulsion en impulsions partielles, une durée d'impulsion et une amplitude d'une impulsion, dans le cas où les besoins en alimentation courants conduiraient à un chevauchement d'impulsions au niveau de différentes sorties

dans lequel l'unité de commande (14) effectue de préférence des modifications en fonction de règles fixes prédéterminées ou de règles réglables par un opérateur, et/ou

dans lequel l'unité de commande compare l'alimentation fournie sous forme d'impulsions par chambre de traitement sur une période de temps avec l'alimentation demandée sur la période de temps, et modifie automatiquement au moins un paramètre d'une impulsion sur la base de la comparaison.

14. Procédé selon la revendication 11, dans lequel l'alimentation électrique est fournie à au moins trois chambres de traitement séparées, dans lequel l'unité de commutation (12a, 12b) a au moins trois sorties d'unité de commutation, chacune connectée à une desdites au moins trois chambres de traitement séparées ; et

dans lequel l'unité de commande (14) en réponse aux besoins en alimentation desdites au moins trois chambres de traitement et en réponse aux données de traitement concernant des traitements dans lesdites au moins trois chambres de traitement, génère des signaux de commande pour fournir le signal continu et des signaux de commande pour fournir sélectivement le signal de sortie alternatif, dans lequel les signaux de commande sont coordonnés de sorte qu'au niveau des sorties d'unité de commutation respectives, qui sont connectées aux chambres de traitement, l'alimentation correspondant aux besoins en alimentation est rendue sensiblement disponible sous forme d'impulsions sur le temps, dans lequel les impulsions pour les chambres de traitement sont décalées dans le temps les unes par rapport aux autres, pendant que les chambres de traitement fonctionnent simultanément, ou dans lequel le procédé comprend les étapes supplémentaires :

la fourniture d'un signal continu ayant une tension et/ou une intensité prédéterminées au niveau d'une entrée d'une unité de commutation supplémentaire (12b) en réponse à un signal de commande provenant de l'unité de commande (14) ;

la formation, à partir du signal continu, d'un signal de sortie alternatif ayant une fréquence prédéterminée d'au moins 40 kHz dans l'unité de commutation supplémentaire (12b) et, en réponse à un signal de commande provenant de l'unité de commande (14), la fourniture sélective du signal de sortie alternatif sous forme d'une impulsion ayant une durée d'impulsion prédéterminée au niveau d'une desdites au moins trois sorties de l'unité de commutation de l'unité de commutation supplémentaire (12b), dont chacune est connectée à une desdites au moins trois chambres de traitement séparées ;

dans lequel l'unité de commande (14), en réponse aux besoins en alimentation desdites au moins trois chambres de traitement et en réponse à des données de traitement concernant des traitements dans lesdites au moins trois chambres de traitement, génère des signaux de commande pour fournir sélectivement le signal de sortie alternatif, dans lequel les signaux de commande sont coordonnés de sorte qu'au niveau des sorties d'unité de commutation respectives, qui sont connectées aux chambres de traitement, sensiblement l'alimentation correspondant aux besoins en alimentation est rendue disponible sur le temps sous forme d'impulsions d'une durée d'impulsion prédéterminée, dans lequel les impulsions qui sont fournies par une des unités de commutation (12a, 12b) sont décalées dans le temps les unes par rapport aux autres, lorsque les impulsions des deux unités de commutation (12a, 12b) risquent de se chevaucher.

15. Procédé selon l'une quelconque des revendications 12 à 14, dans lequel les unités de commutation (12a, 12b) ont au moins une sortie d'unité de commutation connectée à un absorbeur (20), dans lequel l'absorbeur est configuré pour recevoir et absorber une alimentation électrique, et dans lequel l'unité de commande (14) est configurée pour surveiller les traitements dans les chambres de traitement respectives et pour détecter l'apparition ou un risque d'arc ou une occurrence d'un arc dans une des chambres de traitement, et en réponse à cela rediriger le signal de sortie dans l'absorbeur (20), sur une durée d'impulsions ou au moins une partie de celle-ci plutôt que dans une chambre correspondante parmi les chambres de traitement.

Fig. 1

Fig. 2

Fig. 3

EP 3 602 601 B1

Fig. 4

(A)

(B)

(C)

(D)

Fig. 5

EP 3 602 601 B1

32

EP 3 602 601 B1

Fig. 6

(A)

(B)

33

Fig. 7

Fig. 8

Fig. 9

(A)

(B)

Fig. 10

(A)

(A)

**IN DER BESCHREIBUNG AUFGEFÜHRTE DOKUMENTE**

**In der Beschreibung aufgeführte Patentdokumente**

- DE 102015004419 A1
- JP H03247748 A